(19) Europäisches Patentamt
European Patent Office
Office européen des brevets

(11) EP 2 746 786 A1

# (12) EUROPEAN PATENT APPLICATION
published in accordance with Art. 153(4) EPC

(43) Date of publication:
**25.06.2014 Bulletin 2014/26**

(21) Application number: **11876685.6**

(22) Date of filing: **08.12.2011**

(51) Int Cl.:
***G01R 22/00*** *(2006.01)* ***H02J 3/38*** *(2006.01)*

(86) International application number:
**PCT/JP2011/078444**

(87) International publication number:
**WO 2013/080388 (06.06.2013 Gazette 2013/23)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.11.2011 JP 2011261161**

(71) Applicant: **Omron Corporation**
**Kyoto-shi, Kyoto 600-8530 (JP)**

(72) Inventors:
- **MISUMI Shuichi**
  **Kyoto-shi**
  **Kyoto 600-8530 (JP)**
- **IMAI Hiroshi**
  **Kyoto-shi**
  **Kyoto 600-8530 (JP)**
- **KAWABATA Yasuhiro**
  **Kyoto-shi**
  **Kyoto 600-8530 (JP)**
- **SAMESHIMA Hiroshi**
  **Kyoto-shi**
  **Kyoto 600-8530 (JP)**

(74) Representative: **Kilian Kilian & Partner**
**Aidenbachstraße 54**
**81379 München (DE)**

## (54) DETECTOR, METHOD, AND PROGRAM

(57) The present invention relates to a detecting device (112, 311) and method, and a program which can detect a power state easily at low cost. A current transformer (111c) measures current at a side of a commercial power system from a commercial power supply (152) through a connection point (C) of the commercial power system and a power generation system from a solar power generation system configured to supply power having the same frequency as the commercial power supply (152). A current transformer (111p) measures power at the power generation system side through the connection point (C). A decision value calculator (132) calculates a decision value based on a value obtained through multiplication of a measured value of current through the current transformer (111c) and a measured value of current through the current transformer (111p). A flow detector (133) detects a power flow of the commercial power system based on the calculated decision value. The present invention can be applied to a power measuring system configured to measure power in homes, for example.

FIG. 1

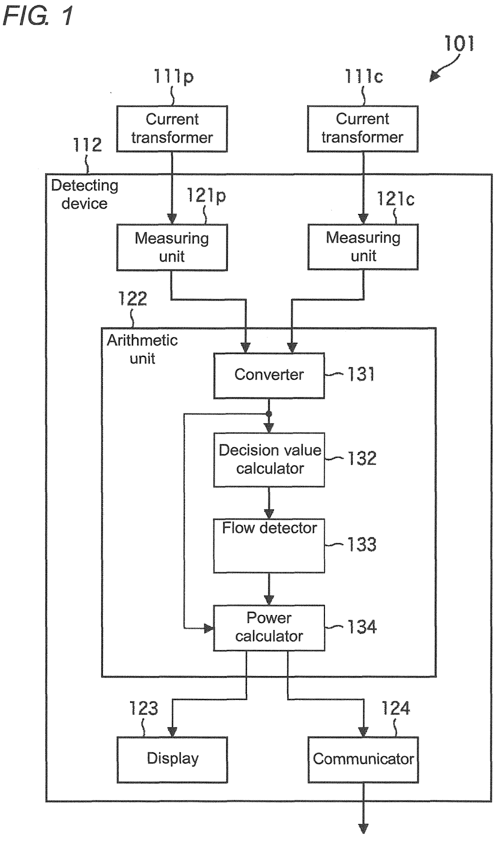


EP 2 746 786 A1

## Description

BACKGROUND

1. FIELD

The present invention relates to a detecting device and method, and a program, and more particularly to a detecting device and method and a program which are suitably used in detection of a power state in facilities provided with a private power generator.

2. RELATED ART

In recent years, with spread of a solar power generation system or start of an excess power purchasing scheme of the solar power generation system, the need for knowing generated power and sold power (excess power), for example, in the solar power generation system, power purchased from a commercial power supply, power consumed in homes also increases in ordinary homes.

Moreover, there has been proposed a technique for detecting a state in which excess power of a private power generator such as a solar power generation system is supplied to a commercial power supply side and power is thus sold (which is hereinafter referred to as a power selling state) or a state in which the power is supplied from the commercial power supply and is thus purchased (which is hereinafter referred to as a power purchasing state) (for example, see Japanese Laid-Open Patent Publications No. 2004 - 279321, No. 2004 - 297959 and No. 11 - 225440). Referring to the inventions described in the Japanese Laid-Open Patent Publications No. 2004 - 279321, No. 2004 - 297959 and No. 11 - 225440, voltage and current of the power system on the commercial power supply side are measured, power is calculated from the measured voltage and current, a power flow is detected based on a sign (plus or minus) of the calculated power, and it is decided whether the power purchasing state or the power selling state is set.

In order to measure voltage in a power system on a commercial power supply side (hereinafter referred to as a commercial power system) in ordinary homes, it is necessary to directly insert a dedicated measuring unit into the commercial power system.

However, the measuring unit highly requires safety and reliability and is manufactured at high cost. Moreover, an installation work for the measuring unit is required and an electrical failure occurs under construction. Furthermore, a qualification is required for the installation work. For this reason, ordinary people cannot perform the installation work. Accordingly, time and labor, cost and the like are increased so that it is impossible to introduce the facilities for simply detecting the power state in homes.

SUMMARY

In consideration of the circumstances, it is an object of the present invention to enable detection of a power state easily at low cost.

A detecting device according to a first aspect of the present invention includes a first current transformer configured to measure first current at a side of a first power system from a commercial power supply through a connection point of the first power system and a second power system from a power generator configured to supply power having the same frequency as the commercial power supply, a second current transformer configured to measure second current at the second power system side through the connection point, a first calculator configured to calculate a decision value based on a value obtained through multiplication of a measured value of the first current and a measured value of the second current, and a detector configured to detect a power flow of the first power system based on the decision value.

In the detecting device according to the first aspect of the present invention, first current is measured at a side of a first power system from a commercial power supply through a connection point of the first power system and a second power system from a power generator configured to supply power having the same frequency as the commercial power supply and second current is measured at the second power system side through the connection point, a decision value is calculated based on a value obtained through multiplication of a measured value of the first current and a measured value of the second current, and a power flow of the first power system is detected based on the decision value.

Accordingly, it is possible to detect the power flow at the commercial power supply side easily at low cost.

The first calculator is configured from an analog multiplication circuit or integration circuit, a digital arithmetic circuit, a microcomputer, various processors or the like, for example. The detector is configured from a comparison circuit or a decision circuit using an operational amplifier or the like, a digital arithmetic circuit, a microcomputer, various processors or the like, for example.

The detector can be caused to decide that the power flow of the first power system is a direction in which power is supplied from the commercial power supply regardless of the decision value if an effective value of the first current is greater than that of the second current.

Consequently, it is possible to prevent the power from being decided to be sold regardless of the purchase of the power from the commercial power supply.

The detector can be caused to decide that the power flow of the first power system is a direction in which power is supplied from the commercial power supply if the effective value of the second current is equal to or smaller than a specified value.

When the current of the power generation system is extremely small and the decision of the flow is unstable, consequently, it is possible to prevent the power from being decided to be sold regardless of the purchase of the power from the commercial power supply.

The first calculator can be caused to calculate, as the decision value, an integrated value of the multiplied value for n cycles (n is a natural number) of the power of the commercial power supply.

Consequently, it is possible to enhance detection precision in the power flow at the commercial power side.

The first calculator can be caused to calculate, as the decision value, a value obtained through multiplication of the measured value of the first current and that of the second current when the second current reaches a positive or negative peak.

Consequently, it is possible to enhance detection precision in the power flow at the commercial power supply side in the case in which a capacitive load is connected.

It is possible to further provide a second calculator configured to calculate first power to be supplied from the commercial power supply to the first power system and second power to be supplied from the power generator to the first power system based on the measured value of the first current and the power flow of the first power system.

Consequently, it is possible to easily measure power sold by a private power generator and power purchased from the commercial power supply at low cost.

The second calculator is configured from a digital arithmetic circuit, a microcomputer, various processors or the like, for example. The first power is set to be the purchased power and the second power is set to be the sold power, for example.

The second calculator can be caused to further calculate third power to be supplied to a load connected to the connection point based on the measured value of the first current, the measured value of the second current and the power flow of the first power system.

Consequently, it is possible to easily measure power consumed by a load at low cost.

The third power is set to be the consumed power, for example.

It is possible to further provide a display configured to display the first power and the second power.

Consequently, it is possible to cause a user to readily grasp the sold power and the purchased power.

The display is configured from various display devices, various light emitting devices or the like, for example.

It is possible to further provide a communicator configured to transmit, to an outside, information including at least one combination in the first power and the second power, and the measured value of the first current and the power flow of the first power system.

Consequently, it is possible to give a notice of the detected power state to an outside.

The communicator is configured from various cable or wireless communicators, for example.

A detecting method according to the first aspect of the present invention by a detecting device configured to detect a power state includes the steps of measuring first current by a first current transformer at a side of a first power system from a commercial power supply through a connection point of the first power system and a second power system from a power generator configured to supply power having the same frequency as the commercial power supply and measuring second current by a second current transformer at the second power system side through the connection point, calculating a decision value based on a value obtained through multiplication of a measured value of the first current and a measured value of the second current, and detecting a power flow of the first power system based on the decision value.

In the detecting method according to the first aspect of the present invention, first current is measured at a side of a first power system from a commercial power supply through a connection point of the first power system and a second power system from a power generator configured to supply power having the same frequency as the commercial power supply and second current is measured at the second power system side through the connection point, a decision value is calculated based on a value obtained through multiplication of a measured value of the first current and a measured value of the second current, and a power flow of the first power system is detected based on the decision value.

Accordingly, it is possible to detect the power flow at the commercial power supply side easily at low cost.

The calculating step is executed by an analog multiplication circuit or integration circuit, a digital arithmetic circuit, a microcomputer, various processors or the like, for example. The detecting step is executed by a comparison circuit or a decision circuit using an operational amplifier or the like, a digital arithmetic circuit, a microcomputer, various processors or the like, for example.

A detecting device according to a second aspect of the present invention includes a calculator configured to calculate a decision value based on a value obtained through multiplication of a measured value of first current measured by a first current transformer at a side of a first power system from a commercial power supply through a connection point of the first power system and a second power system from a power generator configured to supply power having the same frequency as the commercial power supply and a measured value of second current measured by a second current transformer at the second power system side from the connection point, and a detector configured to detect a power flow of the first power system based on the decision value.

In the detecting device according to the second aspect of the present invention, a decision value is calculated based on a value obtained through multiplication of a measured value of first current measured by a first current transformer at a side of a first power system from a commercial power supply through a connection point of the first power system and a second power system from a power generator configured to supply power having the same frequency as the commercial power supply and a measured value of second current measured by a second current transformer at the second power system side from the connection point, and a power flow of the first power system is detected based on the decision value.

Accordingly, it is possible to detect the power flow at the commercial power supply side easily at low cost.

The calculator is configured from an analog multiplication circuit or integration circuit, a digital arithmetic circuit, a microcomputer, various processors or the like, for example. The detector is configured from a comparison circuit or a decision circuit using an operational amplifier or the like, a digital arithmetic circuit, a microcomputer, various processors or the like, for example.

A detecting method according to the second aspect of the present invention by a detecting device configured to detect a power state includes the steps of calculating a decision value based on a value obtained through multiplication of a measured value of first current measured by a first current transformer at a side of a first power system from a commercial power supply through a connection point of the first power system and a second power system from a power generator configured to supply power having the same frequency as the commercial power supply and a measured value of second current measured by a second current transformer at the second power system side from the connection point, and detecting a power flow of the first power system based on the decision value.

In the detecting method according to the second aspect of the present invention, a decision value is calculated based on a value obtained through multiplication of a measured value of first current measured by a first current transformer at a side of a first power system from a commercial power supply through a connection point of the first power system and a second power system from a power generator configured to supply power having the same frequency as the commercial power supply and a measured value of second current measured by a second current transformer at the second power system side from the connection point, and a power flow of the first power system is detected based on the decision value.

Accordingly, it is possible to detect the power flow at the commercial power supply side easily at low cost.

The calculating step is executed by an analog multiplication circuit or integration circuit, a digital arithmetic circuit, a microcomputer, various processors or the like, for example. The detecting step is executed by a comparison circuit or a decision circuit using an operational amplifier or the like, a digital arithmetic circuit, a microcomputer, various processors or the like, for example.

A program according to the second aspect of the present invention causes a computer to execute processing including the steps of calculating a decision value based on a value obtained through multiplication of a measured value of first current measured by a first current transformer at a side of a first power system from a commercial power supply through a connection point of the first power system and a second power system from a power generator configured to supply power having the same frequency as the commercial power supply and a measured value of second current measured by a second current transformer at the second power system side from the connection point, and detecting a power flow of the first power system based on the decision value.

In the computer configured to execute the program according to the second aspect of the present invention, a decision value is calculated based on a value obtained through multiplication of a measured value of first current measured by a first current transformer at a side of a first power system from a commercial power supply through a connection point of the first power system and a second power system from a power generator configured to supply power having the same frequency as the commercial power supply and a measured value of second current measured by a second current transformer at the second power system side from the connection point, and a power flow of the first power system is detected based on the decision value.

Accordingly, it is possible to detect the power flow at the commercial power supply side easily at low cost.

According to the first or second aspect of the present invention, it is possible to detect the power state easily at low cost.

BRIEF DESCRIPTION OF THE DRAWINGS

Fig. 1 is a block diagram showing an embodiment of a power monitoring system to which the present invention is applied;
Fig. 2 is a diagram showing an example of an installation position of a current transformer;
Fig. 3 is a flowchart for explaining power monitor processing;
Fig. 4 is a graph showing an example of a phase difference in voltage and current through a load;
Fig. 5 is a graph showing another example of the phase difference in the voltage and the current through the load;
Fig. 6 is a chart for explaining a method of calculating a decision value;
Fig. 7 is a chart for explaining the method of calculating a decision value;
Fig. 8 is a graph showing an example of a waveform of current in the case in which a capacitive load is connected;
Fig. 9 is a chart for explaining the method of calculating a decision value;
Fig. 10 is a view showing an example of a method of installing a current transformer in the case of a single phase three-wire type;
Fig. 11 is a graph showing an example of a state in which a power factor of a power generation system is minimized;
Fig. 12 is a graph showing an example of the state in which the power factor of the power generation system is minimized;
Fig. 13 is a block diagram showing a variant of the power monitoring system to which the present invention is applied;
Fig. 14 is a flowchart for explaining a first embodiment of power monitor processing to be executed by the power monitoring system in Fig. 13;
Fig. 15 is a graph showing a condition for deciding that a power selling state is set by the processing of Fig. 14;
Fig. 16 is a flowchart for explaining a second embodiment of the power monitor processing to be executed by the power monitoring system in Fig. 13;
Fig. 17 is a graph showing a condition for deciding that a power selling state is set by the processing of Fig. 16; and
Fig. 18 is a block diagram showing an example of a structure of a computer.

DETAILED DESCRIPTION

An embodiment for carrying out the present invention is descried below. Explanation is given in the following order.

1. Embodiment
2. Variant

<1. Embodiment>

[Example of Structure of Power Monitoring System]

Fig. 1 is a block diagram showing an embodiment of power monitoring system 101 to which the present invention is applied, and Fig. 2 shows an example of installation positions of current transformers 111 p and 111c in power monitoring system 101.

A left side of a dotted line in Fig. 2 is set to be an interior of a home in which power monitoring system 101 and solar power generation system 151 are provided. Moreover, a power system from solar power generation system 151 to connection point C, a power system from commercial power supply 152 to connection point C, and a power system from connection point C to load 153 are hereinafter referred to as a power generation system, a commercial power system and a load power system, respectively. In the following, it is assumed that the respective power systems are of a single phase two-wire type in the interior.

In the following, furthermore, voltage of the power generation system (= output voltage of solar power generation system 151) is represented by $v_{p1}$, current is represented by $i_{p1}$, and a direction of arrow Ap1 is set to be a positive direction. In the following, moreover, voltage of the commercial power system (= output voltage of commercial power supply 152) is represented by $v_{c1}$, current is represented by $i_{c1}$, and a direction of arrow Ac1 is set to be a positive direction. Accordingly, current of $i_{p1} + i_{c1}$ flows to the load power system in a direction of arrow Apc.

Power monitoring system 101 serves to detect and monitor a power state in the interior. As described below, power monitoring system 101 detects a power flow of the commercial power system (which is hereinafter referred to as commercial side power) based on current $i_{p1}$ and current $i_{c1}$ and decides whether a power purchasing state or a power selling state is set. Moreover, power monitoring system 101 measures power generated by solar power generation system 151 and excess power of solar power generation system 151, that is, sold power supplied from solar power generation system 151 to the commercial power system. Furthermore, power monitoring system 101 measures purchased power supplied from commercial power supply 152 to the commercial power system and consumed power supplied from solar power generation system 151 and commercial power supply 152 to the load power system and consumed by load 153.

Solar power generation system 151 includes solar battery module 161 and PV (Photo Voltaic) controller 162.

Solar battery module 161 generates DC power by solar power generation and supplies the generated DC power to PV controller 162.

PV controller 162 converts DC power supplied from solar battery module 161 into AC power having almost equal voltage and frequency to those of commercial power supply 152, and furthermore, synchronizes a phase of the voltage of the converted AC power with a phase of the voltage of commercial power supply 152. Then, PV controller 162 outputs the AC power (hereinafter referred to as generated power).

Load 153 is configured from various electrical apparatus, for example, electric appliances such as a refrigerator.

The power generation system and the commercial power system join together and the load power system is branched at connection point C. Connection point C corresponds to a distribution board in a home, for example.

The structure of power monitoring system 101 is described in more detail.

Power monitoring system 101 includes current transformer 111 p, current transformer 111c and detecting device 112. Moreover, detecting device 112 includes measuring unit 121 p, measuring unit 121 c, arithmetic unit 122, display 123 and communicator 124.

Current transformer 111 p is provided on a wiring between solar power generation system 151 and connection point C and measures current $i_{p1}$ of the power generation system. More accurately, current transformer 111 p converts current $i_{p1}$ (primary current) into current $i_{p2}$ (secondary current) and supplies current $i_{p2}$ to measuring unit 121 p. It is assumed that current transformer 111 p is provided in such an orientation that current $i_{p2}$ flows in a direction of arrow Ap2 when current $i_{p1}$ flows in the direction of arrow Ap1.

Measuring unit 121 p converts current $i_{p2}$ into voltage $v_{p2}$ by built-in resistor Rp. Voltage $v_{p2}$ has a positive value when current $i_{p1}$ flows in the direction of arrow Ap1 and current $i_{p2}$ flows in the direction of arrow Ap2, and has a negative value when current $i_{p1}$ flows in a reverse direction to arrow Ap1 and current $i_{p2}$ flows in a reverse direction to arrow Ap2. In other words, a phase of current $i_{p1}$ and that of voltage $v_{p2}$ are coincident with each other when the direction of arrow Ap1 is positive.

Moreover, measuring unit 121 p supplies a signal indicative of voltage $v_{p2}$ (hereinafter referred to as signal $v_{p2}$) to arithmetic unit 122.

Current transformer 111c is provided on a wiring of the interior between commercial power supply 152 and connection point C and measures current $i_{c1}$ of the commercial power system. More accurately, current transformer 111c converts current $i_{c1}$ (primary current) into current $i_{c2}$ (secondary current) and supplies current $i_{c2}$ to measuring unit 121c. It is assumed that current transformer 111 c is provided in such an orientation that current $i_{c2}$ flows in a direction of arrow Ac2 when current $i_{c1}$ flows in a direction of arrow Ac1.

Measuring unit 121c converts current $i_{c2}$ into voltage $v_{c2}$ by built-in resistor Rc. Voltage $v_{c2}$ has a positive value when current $i_{c1}$ flows in the direction of arrow Ac1 and current $i_{c2}$ flows in the direction of arrow Ac2, and has a negative value when current $i_{c1}$ flows in a reverse direction to arrow Ac1 and current $i_{c2}$ flows in a reverse direction to arrow Ac2. In other words, a phase of current $i_{c1}$ and that of voltage $v_{c2}$ are coincident with each other when the direction of arrow Ac1 is positive.

In the power purchasing state in which the commercial side power is supplied in the direction of arrow Ac1, a difference between the phase of voltage $v_{c1}$ and that of voltage $v_{c2}$ (= a phase of current $i_{c1}$) is equal to or smaller than $\pm\pi/2$ in consideration of a power factor of load 153 and a phase synchronization error of PV controller 162. To the contrary, in the power selling state in which the commercial side power is supplied in the reverse direction to arrow Ac1, the difference between the phase of voltage $v_{c1}$ and that of voltage $v_{c2}$ (= the phase of current $i_{c1}$) ranges from $-\pi$ to $-\pi/2$ or from $\pi/2$ to $\pi$. As described below, it is empirically apparent that a general power factor of a load for a home is equal to or higher than $\cos(\pi/6)$.

Moreover, measuring unit 121 c supplies a signal indicative of voltage $v_{c2}$ (hereinafter referred to as signal $v_{c2}$) to arithmetic unit 122.

Arithmetic unit 122 is configured from a microcomputer, for example, and includes converter 131, decision value calculator 132, flow detector 133, and power calculator 134.

Converter 131 converts a value of voltage $v_{p2}$ indicated by signal $v_{p2}$ into a value of current $i_{p1}$ based on a current transformation ratio of current transformer 111 p and a resistance value of resistor Rp which are known, and gives a notice of the value obtained by the conversion to decision value calculator 132 and power calculator 134. Moreover, converter 131 converts the value of voltage $v_{c2}$ indicated by signal $v_{c2}$ into a value of current $i_{c1}$ based on a current transformation ratio of current transformer 111 c and a resistance value of resistor Rc which are known, and gives a notice of the value obtained by the conversion to decision value calculator 132 and power calculator 134.

Decision value calculator 132 calculates a decision value to be used for detecting the flow of the commercial side power based on a measured value of current $i_{p1}$ and that of current $i_{c1}$ as described below. Decision value calculator 132 gives a notice of the decision value obtained by the calculation to flow detector 133.

Flow detector 133 detects the flow of the commercial side power and gives a notice of a detection result to power calculator 134 based on the decision value calculated by decision value calculator 132 as described below.

Power calculator 134 calculates generated power, sold power, purchased power and consumed power based on the measured value of current $i_{p1}$, the measured value of current $i_{c1}$, and the detection result of the flow of the commercial side power as described below. Power calculator 134 gives a notice of the result obtained by the calculation to display 123 and communicator 124.

Display 123 is configured from a display device such as an LCD (Liquid Crystal Display), a light emitting device such as an LED (Light Emitting Diode), or the like, and displays a power state of each unit thereon.

Communicator 124 is configured from various communication devices and transmits power state information indicative of the power state of each unit to an external device. An optional method can be employed for a communication method of communicator 124 regardless of cable or wireless.

[Power Monitor Processing]

Next, power monitor processing to be executed by power monitoring system 101 is described with reference to a flowchart of Fig. 3. The processing is started when a power supply of power monitoring system 101 is turned ON, and is ended when the power supply is turned OFF, for example.

In step S1, power monitoring system 101 measures current. Specifically, current transformer 111 p converts current $i_{p1}$ flowing through the power generation system into current $i_{p2}$ and supplies current $i_{p2}$ to measuring unit 121p. Measuring unit 121 p converts current $i_{p2}$ into voltage $v_{p2}$ and supplies signal $v_{p2}$ Indicative of voltage $v_{p2}$ to converter 131. Moreover, current transformer 111 c converts current $i_{c1}$ flowing through the commercial power system into current $i_{c2}$ and supplies current $i_{c2}$ to measuring unit 121c. Measuring unit 121 c converts current $i_{c2}$ into voltage $v_{c2}$ and supplies signal $v_{c2}$ Indicative of voltage $v_{c2}$ to converter 131.

Converter 131 converts a value of voltage $v_{p2}$ indicated by signal $v_{p2}$ into a value of current $i_{p1}$ and gives a notice of the value obtained by the conversion to decision value calculator 132 and power calculator 134. Moreover, converter 131 converts a value of voltage $v_{c2}$ indicated by signal $v_{c2}$ into a value of current $i_{c1}$ and gives a notice of the value obtained by the conversion to decision value calculator 132 and power calculator 134.

In step S2, decision value calculator 132 calculates a decision value and gives a notice of the calculated decision value to flow detector 133.

In step S3, flow detector 133 detects a flow of the commercial side power based on the decision value and gives a notice of the detected flow to power calculator 134.

With reference to Figs. 4 to 9, description is given to a specific example of a method of detecting the decision value and the flow of the commercial side power in the processing of steps S2 and S3.

For example, in the case in which current $i_{p1}$ and current $i_{c1}$ are continuously measured by an analog circuit or the like, decision value V1 obtained in accordance with the following equation (1) is used.

[Equation 1]

$$D1 = \int_{t=0}^{t=T} ip(t) \times ic(t)dt \qquad \cdots (1)$$

Time T indicates time of one cycle for the power of commercial power supply 152 (= 1 / frequency of commercial power supply 152).

Decision value V1 is a value obtained by integrating, for one cycle, a value calculated though multiplication of an instantaneous value of current $i_{p1}$ and that of current $i_{c1}$ at almost the same time. When the phase of current $i_{p1}$ is represented by $\phi p$ and the phase of current $i_{c1}$ is represented by $\phi c$, accordingly, the decision value is obtained as $V1 \geq 0$ if $|\phi p - \phi c| \leq \pi/2$ is set, and the decision value is obtained as $V1 < 0$ if $\pi/2 < | \phi p - \phi c | \leq \pi$ is set.

As described above, it is empirically apparent that the power factor of the general load for homes is equal to or higher than $\cos(\pi/ 6)$. Therefore, a phase difference between a voltage waveform and a current waveform is equal to or smaller than $\pi/6$.

For example, Fig. 4 is a graph showing a result obtained by applying AC voltage of 100V to a fluorescent light and measuring current through a current transformer. In Fig. 4, an axis of abscissa indicates time and an axis of ordinate indicates voltage and current. Waveform 201 represents a waveform of voltage, waveform 202 represents a waveform of current in the case in which a current transformer is attached in a direction in which a current value is positive when the voltage and the current have the same phase, and waveform 203 represents a waveform of the current in the case in which the current transformer is attached in the direction in which the current value is positive when the voltage and the current have reverse phases to each other. In this case, the difference between the phases of the voltage applied to the fluorescent light and the current flowing to the fluorescent light is approximately 11.5 degrees (< n/6).

Fig. 5 is a graph showing a result obtained by applying AC voltage of 100V to another load and measuring current through the current transformer attached in the direction in which the current value is positive when the voltage and the current have the same phase.

In Fig. 5, an axis of abscissa indicates time and an axis of ordinate indicates voltage and current. Waveform 211 represents a waveform of the voltage, waveform 212 represents a waveform of the current in the case in which the load is a microwave oven, and waveform 213 represents a waveform of the current in the case in which the load is a personal computer and a display. Also in this example, the phase difference between the voltage and the current is smaller than $\pi/6$.

Accordingly, it is possible to assume that the phase difference between voltage $v_{p1}$ and current $i_{p1}$ in the power generation system is equal to or smaller than $\pm\pi/6$. Moreover, it is possible to assume that the phase difference between voltage $v_{c1}$ and current $i_{c1}$ in the commercial power system is equal to or smaller than $\pm\pi/6$ in the power purchasing state and is equal to or smaller than $\pi \pm \pi/6$ in the power selling state. Consequently, it is possible to assume that $|\phi p - \phi c| \leq \pi/3$ is obtained and the decision value is obtained as $V1 \geq 0$ in the power purchasing state. On the other hand, it is possible to assume that $2\pi/3 \leq |\phi p - \phi c| \leq \pi$ is obtained and the decision value is obtained as $V1 < 0$ in the power selling state.

Therefore, it is possible to detect the flow of the commercial side power based on decision value V1. In other words, it is possible to decide that there is set the power purchasing state in which the commercial side power is supplied in the direction of arrow Ac1 with the decision value $V1 \geq 0$ and to decide that there is set the power selling state in which the commercial side power is supplied in the direction of arrow Ac1 with decision value $V1 < 0$.

In the case in which current $i_{p1}$ and current $i_{c1}$ are discretely measured by a digital arithmetic circuit or the like as shown in Fig. 6, for example, decision value V2 calculated in accordance with the following Equation (2) is used.

[Equation 2]

$$D2 = \sum_{k=0}^{m} ip[k] \times ic[k] \qquad \cdots (2)$$

Fig. 6 shows an example of the waveforms of current $i_{p1}$ and current $i_{c1}$ in the power selling state, and an axis of abscissa indicates time and an axis of ordinate indicates a current value. Moreover, circle and square marks in Fig. 6 represent sampling points. For easy understanding of the drawings, Fig. 6 shows only a part of the sampling points.

Moreover, k in the equation (2) indicates numbers of the sampling points of current $i_{p1}$ and current $i_{c1}$, and m indicates the number of sampling operations per cycle. Furthermore, $i_{p1}$ [k] indicates a sampling value of current $i_{p1}$ at a kth sampling point and $i_{c1}$ [k] indicates a sampling value of current $i_{c1}$ at the kth sampling point.

Decision value V2 is a value obtained by integrating, for one cycle, a value calculated though multiplication of the sampling values of current $i_{p1}$ and current $i_{c1}$ at almost the same time. In the same manner as decision value V1, accordingly, the decision value is obtained as $V2 \geq 0$ when $|\phi p - \phi c| \leq \pi/2$ is set, and the decision value is obtained as $V2 < 0$ when $\pi/2 < | \phi p - \phi c | \leq \pi$ is set.

In the same manner as in the case in which decision value V1 is used, accordingly, it is possible to decide that the power purchasing state is set with decision value $V2 \geq 0$ and the power selling state is set with decision value $V2 < 0$.

For example, in the case in which a value of current $i_{p1}$ and a value of current $i_{c1}$ are set to be $i_{p1}(t_{max})$ and $i_{c1}(t_{max})$ at time $t_{max}$ that current $i_{p1}$ reaches a positive peak, respectively as shown in Fig. 7, decision value V3 calculated in accordance with the following equation (3) may be used.

$$V3 = i_{p1}(t_{max}) \times i_{c1}(t_{max}) \qquad \cdots (3)$$

Also in this case, in the same manner as the case in which decision value V1 is used, it is possible to decide that the power purchasing state is set with decision value $V3 \geq 0$ and to decide that the power selling state is set with decision value $V3 < 0$.

By utilizing value $i_{p1}$ ($t_{min}$) of current $i_{p1}$ and value $i_{c1}$ ($t_{min}$) of current $i_{c1}$ at time $t_{min}$ that current $i_{p1}$ reaches a negative peak respectively, similarly, it is also possible to use decision value V4 calculated in accordance with the following equation (4).

$$V4 = i_{p1}(t_{min}) \times i_{c1}(t_{min}) \qquad \cdots (4)$$

Also in this case, in the same manner as the case in which decision value V3 is used, it is possible to decide that the power purchasing state is set with decision value V4 ≥ 0 and to decide that the power selling state is set with decision value V4 < 0.

Fig. 8 shows an example of waveforms of current $i_{p1}$ and current $i_{c1}$ in the power selling state in the case in which load 153 is mainly configured from a capacitive load (a capacitor load). An axis of abscissa indicates time and an axis of ordinate indicates current.

As shown in the drawing, in the case in which load 153 is mainly configured from the capacitive load, current $i_{p1}$ of the power generation system has a pulse-shaped waveform in which a sharp peak appears for a short period of time. In some cases, detection precision in the flow of the commercial side power is higher in the use of decision value V3 or decision value V4 to be the integrated value of current $i_{p1}$ and current $i_{c1}$ at time that current $i_{p1}$ of the power generation system reaches a peak than the use of decision value V1 or decision value V2 obtained by integrating, for one cycle, the value calculated through the multiplication of current $i_{p1}$ and current $i_{c1}$.

In the case in which current $i_{p1}$ and current $i_{c1}$ cannot be measured at the same time for reason of a short sampling interval or the like, it is also possible to calculate the decision value by using current $i_{p1}$ and current $i_{c1}$ measured in different cycles, for example.

In the case in which current $i_{p1}$ and current $i_{c1}$ are continuously measured, for example, decision value V5 calculated in accordance with the following equation (5) is used.

[Equation 3]

$$D5 = \int_{t=0}^{t=T} ip(t) \times ic(t+nT)dt \qquad \cdots (5)$$

n in the equation (5) is set to be a natural number.

Decision value V5 is obtained by integrating, for one cycle, a value calculated through multiplication of the instantaneous value of current $i_{p1}$ and an instantaneous value of current $i_{c1}$ with a delay of n cycles. In the same manner as in the case in which decision value V1 is used, accordingly, it is possible to decide that the power purchasing state is set with decision value V5 ≥ 0 and to decide that the power selling state is set with decision value V5 < 0.

In the case in which current $i_{p1}$ and current $i_{c1}$ are discretely measured, for example, decision value V6 calculated in accordance with the following equation (6) is used.

[Equation 4]

$$D6 = \sum_{k=0}^{m} ip[k] \times ic[n \times m + k] \qquad \cdots (6)$$

As shown in Fig. 9, decision value V6 is obtained by integrating, for one cycle, a value calculated through multiplication of the sampling value of current $i_{p1}$ and a sampling value of current $i_{c1}$ with a delay of n cycles. In the same manner as in the case in which decision value V1 is used, accordingly, it is possible to decide that the power purchasing state is set with decision value V6 ≥ 0 and to decide that the power selling state is set with decision value V6 < 0.

Returning to Fig. 3, in step S4, power calculator 134 calculates power of each unit. Specifically, power calculator 134 calculates generated power $P_p$ in accordance with the following equation (7) if power generated from solar power generation system 151 is represented by Pp.

$$P_p = vr_{p1} \times ir_{p1} \times PF_p \quad \cdots (7)$$

$vr_{p1}$ represents an effective value of voltage $v_{p1}$ and a nominal value of output voltage of solar power generation system 151 is used, for example. For the use, a measured value of the effective value of voltage $v_{p1}$ may be acquired from solar power generation system 151.

$ir_{p1}$ represents an effective value of current $i_{p1}$ which is calculated based on a measured value of current $i_{p1}$.

$PF_p$ represents the power factor of the power generation system and is a constant set based on an experimental result, an actual measurement result, a theoretical equation or the like, for example.

In the case in which it is decided that the power purchasing state is set when purchased power is represented by $P_{cb}$ and sold power is represented by $P_{cs}$, power calculator 134 calculates purchased power $P_{cb}$ and sold power $P_{cs}$ in accordance with the following equations (8) and (9).

$$P_{cb} = vr_{c1} \times ir_{c1} \times PF_c \quad \cdots (8)$$

$$P_{cs} = 0 \quad \cdots (9)$$

$vr_{c1}$ represents an effective value of voltage $v_{c1}$ and nominal voltage of commercial power supply 152 is used, for example. The output voltage of solar power generation system 151 is controlled to be equal to the voltage of commercial power supply 152. For this reason, the measured value of the effective value of voltage $v_{p1}$ may be acquired from solar power generation system 151 and thus used as voltage $vr_{c1}$.

$ir_{c1}$ represents an effective value of current $i_{c1}$ which is calculated based on a measured value of current $i_{c1}$.

$PF_c$ represents the power factor of the commercial power system and is a constant set based on an experimental result, an actual measurement result, a theoretical equation or the like, for example.

On the other hand, if it is decided that the power selling state is set, power calculator 134 calculates purchased power $P_{cb}$ and sold power $P_{cs}$ in accordance with the following equations (10) and (11).

$$P_{cb} = 0 \quad \cdots (10)$$

$$P_{cs} = vr_{c1} \times ir_{c1} \times PF_c \quad \cdots (11)$$

A right side of equation (8) is equal to that of equation (11).

If it is decided that the power purchasing state is set, power calculator 134 calculates load power $P_l$ of load 153 in accordance with the following equation (12).

$$P_l = vr_{c1} \times (ir_{p1} + ir_{c1}) \times PF_l \quad \cdots (12)$$

$PF_l$ represents the power factor of the load power system and is a constant set based on an experimental result, an actual measurement result, a theoretical equation or the like, for example.

On the other hand, if it is decided that the power selling state is set, power calculator 134 calculates load power $P_l$ of load 153 in accordance with the following equation (13).

$$P_l = vr_{c1} \times (ir_{p1} - ir_{c1}) \times PF_l \quad \cdots (13)$$

Then, power calculator 134 gives a notice of a calculated value of the power of each unit to display 123 and communicator 124.

In step S5, display 123 displays the power state of each step. For example, display 123 displays generated power $P_p$, sold power $P_{cs}$, purchased power $P_{cb}$ and load power $P_l$ which are calculated by using a numerical value, a time series graph or the like. For example, display 123 displays whether the power purchasing state or the power selling state is set in a character, a symbol, an icon or the like over a screen or carries out indication through lighting, flashing, a color variation or the like by means of an LED etc.

Consequently, a user can grasp the power state of each unit in a home.

In step S6, communicator 124 gives a notice of the power state of each unit. Specifically, communicator 124 transmits, to an external device, power state information including generated power $P_p$, sold power $P_{cs}$, purchased power $P_{cb}$ and load power $P_l$ which are calculated, and whether the power purchasing state or the power selling state is set.

The external device to be a transmitting destination stores received information and analyzes a use situation of power or the like based on the received information, for example.

Furthermore, the measured values of current $i_{p1}$ and current $i_{c1}$ may be included in the power state information. Moreover, all of the information do not always need to be transmitted but the information to be transmitted may be selected depending on necessity of the device to be the transmitting destination, for example.

In addition, the transmission of the power state information does not always need to be performed by loop process for power monitor processing every time but is preferably carried out in a predetermined timing every predetermined period or when a storage amount of information exceeds a predetermined amount, for example. Alternatively, the power state information may be transmitted according to a request given from the external device.

Then, the processing returns to step S1 and processing after step S1 is executed.

As described above, it is possible to detect the flow of the commercial side power by simply installing only current transformers 111 p and 111 c in the power system and measuring current $i_{p1}$ and current $i_{c1}$ without disposing a voltage measuring unit in the power system. Moreover, it is possible to measure the generated power, the sold power, the purchased power and the consumed power.

Therefore, it is possible to install power monitoring system 101 safely without a power failure, to easily provide power monitoring system 101, and furthermore, to reduce necessary cost. As a result, it is possible to detect the power state easily at low cost. By omitting a high voltage measuring unit which greatly requires safety and reliably, furthermore, it is possible to enhance the safety and reliability of the whole power monitoring system 101.

<2. Variant>

Although the description has been given to the example in which the present invention is applied to the single phase two-wire type power system , the present invention can also be applied to a power system of a single phase three-wire type.

Fig. 10 shows an example of a method of installing a current transformer in the case of the single phase three-wire type. As shown in Fig. 10, it is preferable to provide two current transformers including current transformer 251 and current transformer 252 between voltage line L1 and neutral line N (which is hereinafter referred to as an L1 phase) and between voltage line L2 and neutral line N (which is hereinafter referred to as an L2 phase), respectively.

In the case of the single phase three-wire type, when current $i_{p1}$ and current $i_{c1}$ are to be measured discretely and serially, it is preferable to continuously measure current having the same phase in order of current $i_{p1}$ having an L1 phase, current $i_{c1}$ having the L1 phase, current $i_{p1}$ having an L2 phase, current $i_{c1}$ having the L2 phrase ···, for example.

Although the description has been given to the example in which the value obtained by the multiplication of current $i_{p1}$ and current $i_{c1}$ is integrated for one cycle when decision values V1, V2, V5 and V6 are to be calculated, it is also possible to carry out the integration for n cycles (n is a natural number of two or more).

Furthermore, the installing directions of current transformers 111 p and 111 c are not restricted to the above example but can be set to optional directions. In the case in which only one of current transformers 111 p and 111 c is installed in a reverse direction to that in the above example, a decision result of the flow of the commercial side power is reverse to that in the above example.

Although the values of voltage $v_{p2}$ and voltage $v_{c2}$ are converted into the values of current $i_{p1}$ and current $i_{c1}$ and the decision value is then calculated in the above description, moreover, it is also possible to calculate the decision value by directly using voltage $v_{p2}$ and voltage $v_{c2}$. In this case, it is basically sufficient to simply replace current $i_{p1}$ and current $i_{c1}$ in the equations (1) to (6) with voltage $v_{p2}$ and voltage $v_{c2}$.

In power monitoring system 101, furthermore, the power factor of current $i_{p1}$ is minimized immediately before solar battery module 161 starts power generation or immediately after it ends the power generation in some cases. For example, Fig. 11 shows an example of a transition for the effective value of current $i_{p1}$ before or after solar battery module 161 starts the power generation in the morning. A portion surrounded by a circle in Fig. 11 illustrates a time zone immediately before the start of the power generation by solar battery module 161. As in this example, current $i_{p1}$ flows regardless of no power generation of solar battery module 161 in some cases. At this time, current $i_{p1}$ is mainly generated

due to flow of current into a capacitive load such as a capacitor in PV controller 162, and a phase is greatly different from that of current $i_{p1}$ in the power generation of solar battery module 161.

On the other hand, Fig. 12 shows an example of a transition for the effective value of current $i_{p1}$ before or after solar battery module 161 stops the power generation in the evening. A portion surrounded by a circle in Fig. 12 illustrates a time zone immediately after the stop of the power generation by solar battery module 161. As in this example, current $i_{p1}$ flows regardless of no power generation of solar battery module 161 in some cases. At this time, current $i_{p1}$ is also generated mainly due to flow of current into a capacitive load such as a capacitor in PV controller 162, and a phase is greatly different from that of current $i_{p1}$ in the power generation of solar battery module 161.

In the time zones surrounded by the circles in Figs. 11 and 12, thus, current $i_{p1}$ having a greatly different phase from that in the power generation of solar battery module 161 flows. Consequently, there is a fear that the flow of the commercial side power might be detected reversely to an actual flow. In other words, although solar battery module 161 does not generate power, it is decided that the flow of the commercial side power is set into the power selling state. Although the power is purchased from commercial power supply 152, there is a fear that the power might be decided to be sold. If this is caused when high power is consumed by load 153 and a large amount of power is purchased from commercial power supply 152, for example, considerable deviation occurs in a result of the calculation of the sold power and the purchased power.

Fig. 13 shows an example of a structure of power monitoring system 301 which prevents erroneous detection in the flow of the commercial side power. In Fig. 13, corresponding portions to Fig. 1 have the same reference numerals and portions subjected to the same processing are properly omitted because the explanation is repeated.

Power monitoring system S301 is different from power monitoring system 101 in Fig. 1 in that detecting device 311 is provided in place of detecting device 112. Detecting device 311 is different from detecting device 112 in that arithmetic unit 321 is provided in place of arithmetic unit 122.

Arithmetic unit 321 is different from arithmetic unit 122 in that flow detector 331 is provided in place of flow detector 133.

Flow detector 331 detects a flow on the commercial side power based on the measured values of current $i_{p1}$ and current $i_{c1}$ in addition to a decision value calculated by decision value calculator 132, and gives a notice of a detected result to power calculator 134.

With reference to a flowchart of Fig. 14, description is given to a first embodiment of power monitor processing to be executed by power monitoring system 301. This processing is started when a power supply of power monitoring system 301 is turned ON and is ended when the power supply is turned OFF, for example.

The processing of steps S101 to S103 are the same as those of steps S1 to S3 of Fig. 3. In other words, current $i_{p1}$ and current $i_{c1}$ are measured and a decision value is calculated, and a flow of commercial side power is decided based on the decision value.

In step S104, flow detector 331 decides whether a result of the decision in the processing of step S103 is set into the power selling state or not. If it is decided that the result of the decision is set into the power selling state, the processing proceeds to step S105.

In step S105, flow detector 331 decides whether the current of the commercial power system is larger than the current of the power generation system or not. In other words, if flow detector 331 compares the effective value of current $i_{c1}$ with that of current $i_{p1}$ and decides that the effective value of current $i_{c1}$ is greater, the processing proceeds to step S106.

In step S106, flow detector 331 corrects the flow into the power purchasing state. In other words, in the power selling state of the flow and in a state in which the effective value of current $i_{c1}$ is greater than that of current $i_{p1}$, higher power than the power generation amount of solar power generation system 151 is supplied to commercial power supply 152 side. This state cannot really occur. For this reason, flow detector 331 decides that erroneous detection in the flow of commercial side power occurs, and corrects the result of the detection in the flow from the power selling state to the power purchasing state. Then, flow detector 331 gives a notice of the corrected flow to power calculator 134.

Thereafter, the processing proceeds to step S107.

On the other hand, if it is decided that the effective value of current $i_{c1}$ is equal to or smaller than the effective value of current $i_{p1}$ in step S105, the processing of step S106 is skipped so that the flow is not corrected and the processing proceeds to step S107. At this time, flow detector 331 gives power calculator 134 a notice of the flow decided in the processing of step S103.

If it is decided that the decision result is the power purchasing state in step S104, moreover, the processing of steps S105 and S106 is skipped and the processing proceeds to step S107. At this time, flow detector 331 gives power calculator 134 a notice that the flow is set into the power purchasing state.

In steps S107 to S109, subsequently, the same processing as those of steps S4 to S6 in Fig. 3 are executed and the processing then returns to step S101, and the processing after step S101 are executed.

Fig. 15 is a graph indicative of a condition for deciding that the power selling state is set in the processing of Fig. 14. In Fig. 15, it is supposed that the effective value of current $i_{p1}$ is set to be positive when phase difference $\phi p - \phi c$ between current $i_{p1}$ and current $i_{c1}$ is $\pi/2 < | \phi p - \phi c | \leq \pi$ (that is, the decision value < 0) and the effective value of

current $i_{p1}$ is set to be negative when phase difference $\phi p - \phi c$ between current $i_{p1}$ and current $i_{c1}$ is $|\phi p - \phi c| \leq \pi/2$ (that is, the decision value $\geq 0$). Moreover, a slanted line part in Fig. 15 indicates a region decided to be set into the power selling state and the other parts indicate a region decided to be set into the power purchasing state.

As shown in Fig. 15, the power selling state is decided to be set with 0 < the effective value of current $i_{c1} \leq$ the effective value of current $i_{p1}$, and the power purchasing state is decided to be set in the other cases. In other words, even if the decision value < 0 is obtained, the power selling state is not decided to be set but the power purchasing state is decided to be set without the effective value of current $i_{c1} \leq$ the effective value of current $i_{p1}$. In other words, when a calculated value of the sold power is greater than that of the generated power even if the power selling state is decided to be set based on the decision value, the power purchasing state is decided to be set.

On the other hand, if the decision value $\geq 0$ is obtained, the power purchasing state is decided to be set regardless of the relationship between current $i_{c1}$ and current $i_{p1}$ in the same manner as the processing of Fig. 3.

With reference to a flowchart of Fig. 16, next, description is given to a second embodiment of the power monitor processing to be executed by power monitoring system 301. This processing is started when a power supply of power monitoring system 301 is turned ON and is ended when the power supply is turned OFF, for example.

In step S201, current $i_{p1}$ and current $i_{c1}$ are measured in the same manner as the processing of step S1 in Fig. 3.

In step S202, flow detector 331 decides whether the current of the power generation system is equal to or smaller than a specified value or not. In other words, if flow detector 331 compares the effective value of current $i_{p1}$ with a predetermined specified value and decides that the effective value of current $i_{p1}$ is greater than the specified value, the processing proceeds to step S203.

The specified value is set to be a value with which the flow is decided stably, for example, a value which is ten times as great as a detection limit of the current.

In step S203, the decision value is calculated in the same manner as the processing of step S2 in Fig. 3. In step S204, the flow of the commercial side power is decided in the same manner as the processing of step S3 in Fig. 3.

In step S205, it is decided whether the decision result is set into the power selling state or not in the same manner as the processing of step S104 in Fig. 14. If it is decided that the decision result is the power selling state, the processing proceeds to step S206.

In step S206, flow detector 331 decides whether the current of the commercial power system is larger than that of the power generation system or not. At this time, flow detector 331 decides that the current of the commercial power system is larger than the current of the power generation system when the following equation (14) is satisfied differently from the processing of step S105 in Fig. 14, for example.

Effective value of current $i_{c1} > a \times$ effective value of current $i_{p1} + b \cdots (14)$

The constant a is equal to or greater than one and is set based on an assumed value of a gain error in measuring units 121 p and 121 c, converter 131 or the like, for instance. Moreover, the constant b is equal to or greater than zero and is set based on an assumed value of a noise error in measuring units 121 p and 121 c, converter 131 or the like, for example.

Consequently, the relationship between the current of the commercial power system and that of the power generation system can be decided more accurately in consideration of the gain error or the noise error.

If it is decided that the current of the commercial power system is larger than that of the power generation system, the processing proceeds to step S207.

In step S206, it is also possible to use the same deciding method as that in step S105 of Fig. 14. To the contrary, in step S105 of Fig. 14, it is also possible to use the same deciding method as that of step S206.

In step S207, the flow is corrected into the power purchasing state in the same manner as the processing of step S106 in Fig. 14, and the corrected flow is given as a notice to power calculator 134. Then, the processing proceeds to step S209.

On the other hand, if it is decided that the current of the commercial power system is equal to or smaller than that of the power generation system in step S206, the processing of step S207 is skipped and the flow is not corrected, and the processing proceeds to step S209. At this time, flow detector 331 gives power calculator 134 a notice of the flow decided in the processing of step S204.

If it is decided that the decision result is the power purchasing state in step S205, moreover, the processing of steps S206 and S207 is skipped and the processing proceeds to step S209. At this time, flow detector 331 gives power calculator 134 a notice that the flow is set into the power purchasing state.

If it is decided that the effective value of current $i_{p1}$ is equal to or smaller than the specified value in step S202, furthermore, the processing proceeds to step S208.

In step S208, flow detector 331 decides that the flow is set into the power purchasing state. In other words, if the effective value of current $i_{p1}$ is equal to or smaller than the specified value, it is decided that the flow is set into the power purchasing state regardless of the decision value. Then, flow detector 331 gives power calculator 134 a notice that the flow is set into the power purchasing state. Thereafter, the processing proceeds to step S209.

Consequently, it is possible to prevent the flow from being erroneously detected as the power selling state

when current $i_{p1}$ takes a minimum value, for example, around 6 : 45 and around 17 : 35 at an edge of the time zone surrounded by the circles in Figs. 11 and 12.

On the other hand, in the case in which the power generation amount of solar battery module 161 is small and current $i_{p1}$ is small, there is a possibility that the power purchasing state might be detected erroneously regardless of the flow in the power selling state. However, excess power is generated when the power generation amount of solar battery module 161 is small, the power selling state is rarely set. Consequently, there is a very low possibility that the erroneous detection might occur. Even if the erroneous detection occurs, moreover, it is supposed that influence of the erroneous detection is very small because the amount of power is small.

Then, the same processing as those in steps S4 to S6 in Fig. 3 are executed in steps S209 to S211 and the processing thereafter returns to step S201, and the processing after step S201 are executed.

Fig. 17 is the same graph as Fig. 15 and shows a condition for deciding that the power selling state is set in the processing of Fig. 16. A slanted line part in Fig. 17 indicates a region decided to be set into the power selling state, and the other portions indicate a region decided to be set into the power purchasing state.

As shown in Fig. 17, it is decided that the power selling state is set if 0 < effective value of current $i_{c1} \leq a \times$ effective value of current $i_{p1}$ + b and effective value of current $i_{p1}$ > specified value c are taken, and it is decided that the power purchasing state is set in the other cases.

In other words, also when the decision value < 0 is obtained, the power selling state is not decided to be set but the power purchasing state is decided to be set if neither 0 < effective value of current $i_{c1} \leq a \times$ effective value of current $i_{p1}$ + b nor effective value of current $i_{p1}$ > specified value c are taken. In other words, also in the case in which the power selling state is decided to be set based on the decision value, the power purchasing state is decided to be set when the calculated value of the sold power is greater than the calculated value of the generated power + an error or the effective value of current $i_{p1}$ is equal to or smaller than the specified value c.

On the other hand, if the decision value ≥ 0 is obtained, the power purchasing state is decided to be set regardless of the relationship between current $i_{c1}$ and current $i_{p1}$ in the same manner as the processing of Fig. 3.

In the embodiment according to the present invention, moreover, it is possible to employ a private power generator of an optional type, for example, wind power generation, diesel power generation, a fuel cell or the like in addition to the solar power generation.

In addition, the present invention can be applied to power systems of various facilities including private power generators, for example, a building, a factory, commercial facilities, public facilities and the like in addition to ordinary homes.

[Example of Structure of Computer]

The above serial processing of detecting devices 112 and 311 can also be executed by hardware or software. In the case in which the serial processing are executed by software, a program constituting the software is installed into a computer. The computer includes a computer incorporated in dedicated hardware, a general-purpose personal computer capable of executing various functions by installing various programs and the like, for example.

Fig. 18 is a block diagram showing an example of a structure of hardware in a computer configured to execute the serial processing in accordance with a program.

In the computer, CPU (Central Processing Unit) 401, ROM (Read Only Memory) 402 and RAM (Random Access Memory) 403 are connected mutually through bus 404.

Input/output interface 405 is further connected to bus 404. Input unit 406, output unit 407, storage unit 408, communicator 409 and drive 410 are connected to input/output interface 405.

Input unit 406 is configured from a keyboard, a mouse, a microphone and the like. Output unit 407 is configured from a display, a speaker and the like. Storage unit 408 is configured from a hard disk, a nonvolatile memory and the like. Communicator 409 is configured from a network interface and the like. Drive 410 drives removable media 411 such as a magnetic disk, an optical disk, a magneto-optical disk or a semiconductor memory.

In the computer having the structure described above, CPU 401 loads a program stored in storage unit 408 into RAM 403 through input/output interface 405 and bus 404 and executes the program, for example. Thus, the above serial processing are carried out.

The program to be executed by the computer (CPU 401) can be recorded in removable media 411 serving as package media and can be thus offered, for example. Moreover, the program can be provided through cable or wireless transmission media such as a local area network, internet or digital satellite broadcasting.

In the computer, the program can be installed into storage unit 408 through input/output interface 405 by attachment of removable media 411 to drive 410. Moreover, the program can be received by communicator 409 through the cable or wireless transmission media and can be thus installed into storage unit 408. In addition, the program can be previously installed into ROM 402 and storage unit 408.

The program to be executed by the computer may be a program to be processed in time series in order described in this specification or may be a program to be processed in parallel or in a necessary timing when calling is performed.

In this specification, moreover, it is assumed that the terms of the system imply a whole apparatus configured from devices, units and the like.

Furthermore, the embodiment according to the present invention is not restricted to the embodiments described above but various changes can be made without departing from the gist of the present invention.

## Claims

1. A detecting device (112, 311) configured to detect a power state **characterized by** a first current transformer (111 p, 111c) configured to measure first current at a side of a first power system from a commercial power supply (152) through a connection point (C) of the first power system and a second power system from a power generator configured to supply power having the same frequency as the commercial power supply (152), a second current transformer (251, 252) configured to measure second current at the second power system side through the connection point (C), a first calculator (132) configured to calculate a decision value based on a value obtained through multiplication of a measured value of the first current and that of the second current, and a detector (133) configured to detect a power flow of the first power system based on the decision value.

2. The detecting device (112, 311) according to claim 1 **characterized in that** the detector (133) decides that the power flow of the first power system is a direction in which power is supplied from the commercial power supply (152) regardless of the decision value if an effective value of the first current is greater than that of the second current.

3. The detecting device (112, 311) according to claim 1 or 2 **characterized in that** the detector (133) decides that the power flow of the first power system is a direction in which power is supplied from the commercial power supply (152) if the effective value of the second current is equal to or smaller than a specified value.

4. The detecting device (112, 311) according to any of claims 1 to 3 **characterized in that** the first calculator (132) calculates, as the decision value, an integrated value of the multiplied value for n cycles (n is a natural number) of the power of the commercial power supply (152).

5. The detecting device (112, 311) according to any of claims 1 to 3 **characterized in that** the first calculator (132) is calculated, as the decision value, a value obtained through multiplication of the measured value of the first current and that of the second current when the second current reaches a positive or negative peak.

6. The detecting device (112, 311) according to any of claims 1 to 5 **characterized by** second calculator (134) configured to calculate first power to be supplied from the commercial power supply (152) to the first power system and second power to be supplied from the power generator to the first power system based on the measured value of the first current and the power flow of the first power system.

7. The detecting device (112, 311) according to claim 6 **characterized in that** the second calculator (134) further calculates third power to be supplied to a load connected to the connection point (C) based on the measured value of the first current, the measured value of the second current and the power flow of the first power system.

8. The detecting device (112, 311) according to claim 6 **characterized by** a display configured to display the first power and the second power.

9. The detecting device (112, 311) according to claim 6 **characterized by** a communicator configured to transmit, to an outside, information including at least one combination in the first power and the second power, and the measured value of the first current and the power flow of the first power system.

10. A method of detecting a power state by a detecting device (112, 311) **characterized by** the steps of measuring first current by a first current transformer (111 p, 111c) at a side of a first power system from a commercial power supply (152) through a connection point (C) of the first power system and a second power system from a power generator configured to supply power having the same frequency as the commercial power supply (152) and measuring second current by a second current transformer (251, 252) at the second power system side through the connection point (C), calculating a decision value based on a value obtained through multiplication of a measured value of the first current and that of the second current, and detecting a power flow of the first power system based on the decision value.

**11.** A detecting device (112, 311) **characterized by** a calculator (132) configured to calculate a decision value based on a value obtained through multiplication of a measured value of first current measured by a first current transformer (111 p, 111 c) at a side of a first power system from a commercial power supply (152) through a connection point (C) of the first power system and a second power system from a power generator configured to supply power having the same frequency as the commercial power supply (152) and a measured value of second current measured by a second current transformer (251, 252) at the second power system side from the connection point (C), and a detector (133) configured to detect a power flow of the first power system based on the decision value.

**12.** A method of detecting a power state by a detecting device (112, 311) **characterized by** the steps of calculating a decision value based on a value obtained through multiplication of a measured value of first current measured by a first current transformer (111 p, 111 c) at a side of a first power system from a commercial power supply (152) through a connection point (C) of the first power system and a second power system from a power generator configured to supply power having the same frequency as the commercial power supply (152) and a measured value of second current measured by a second current transformer (251, 252) at the second power system side from the connection point (C), and detecting a power flow of the first power system based on the decision value.

**13.** A program for causing a computer to execute processing **characterized by** the steps of calculating a decision value based on a value obtained through multiplication of a measured value of first current measured by a first current transformer (111 p, 111 c) at a side of a first power system from a commercial power supply (152) through a connection point (C) of the first power system and a second power system from a power generator configured to supply power having the same frequency as the commercial power supply (152) and a measured value of second current measured by a second current transformer (251, 252) at the second power system side from the connection point (C), and detecting a power flow of the first power system based on the decision value.

FIG. 1

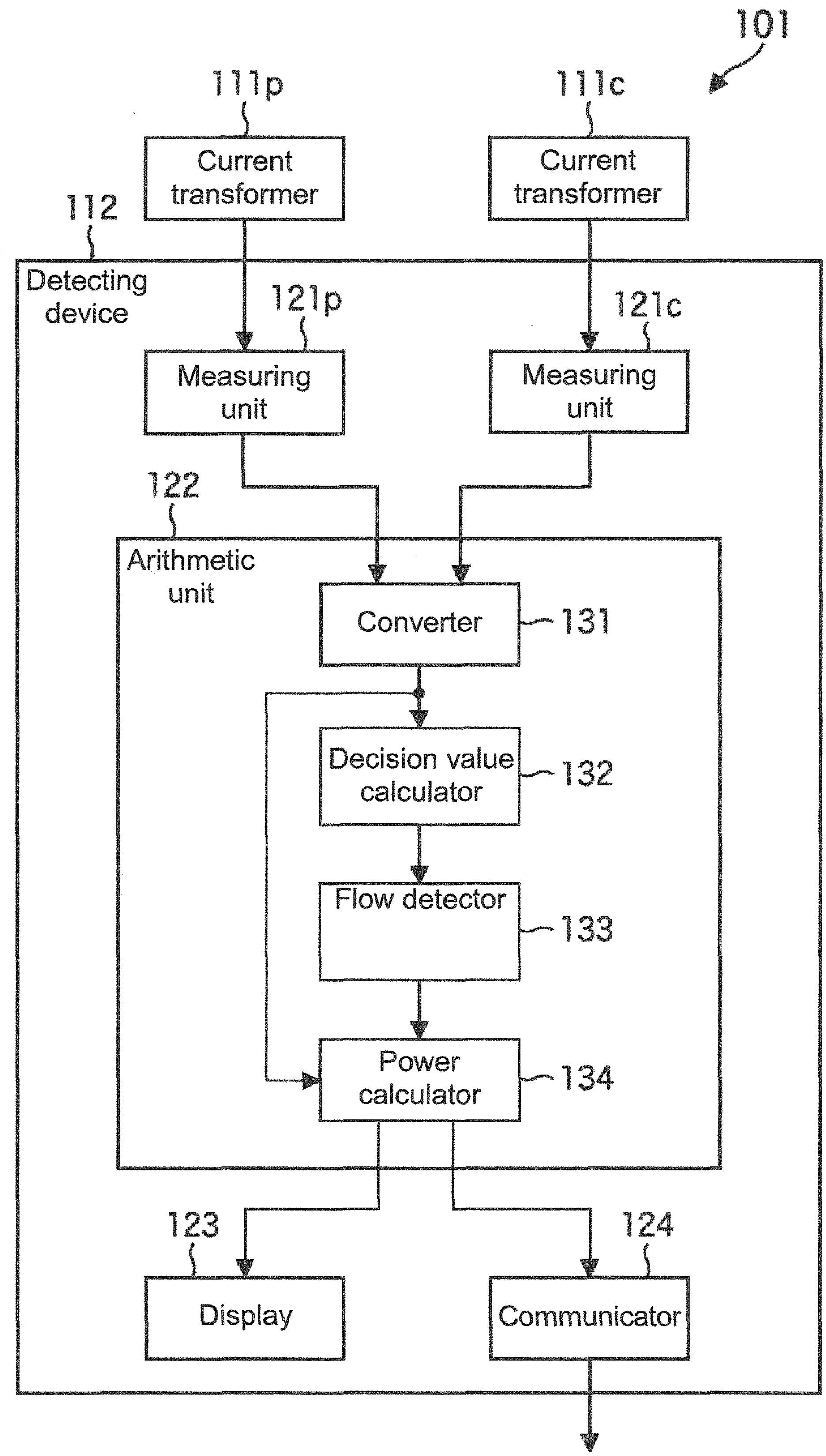
101
111p
Current transformer
111c
Current transformer
112
Detecting device
121p
Measuring unit
121c
Measuring unit
122
Arithmetic unit
Converter
131
Decision value calculator
132
Flow detector
133
Power calculator
134
123
Display
124
Communicator

FIG. 2

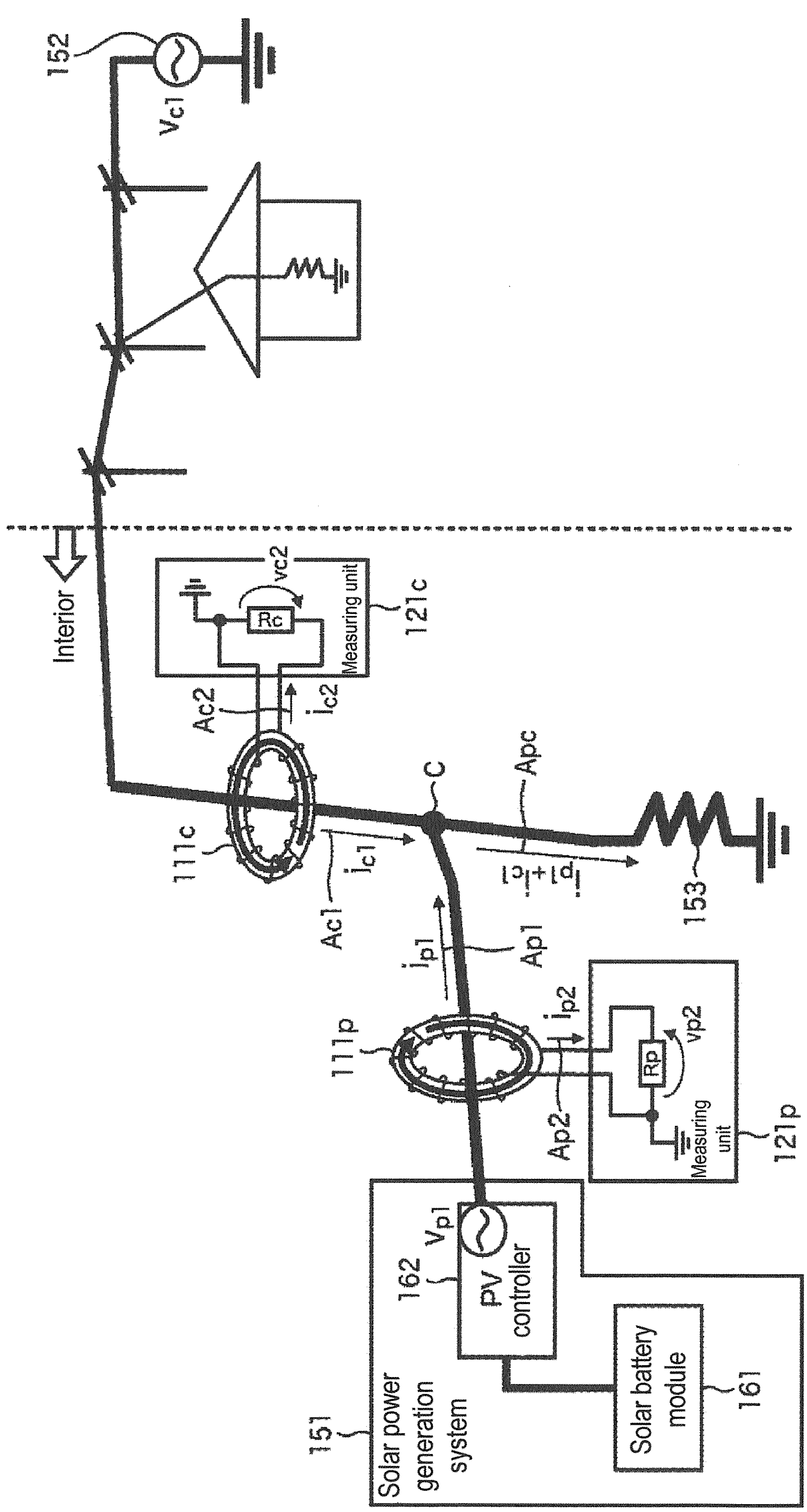
152
$v_{c1}$
Interior
Rc
vc2
Measuring unit
121c
Ac2
$i_{c2}$
C
Apc
111c
$i_{c1}$
Ac1
$i_{p1}+i_{c1}$
153
$i_{p1}$
Ap1
111p
$i_{p2}$
Rp
vp2
Ap2
Measuring unit
121p
$V_{p1}$
162
PV controller
Solar battery module
161
151
Solar power generation system

FIG. 3

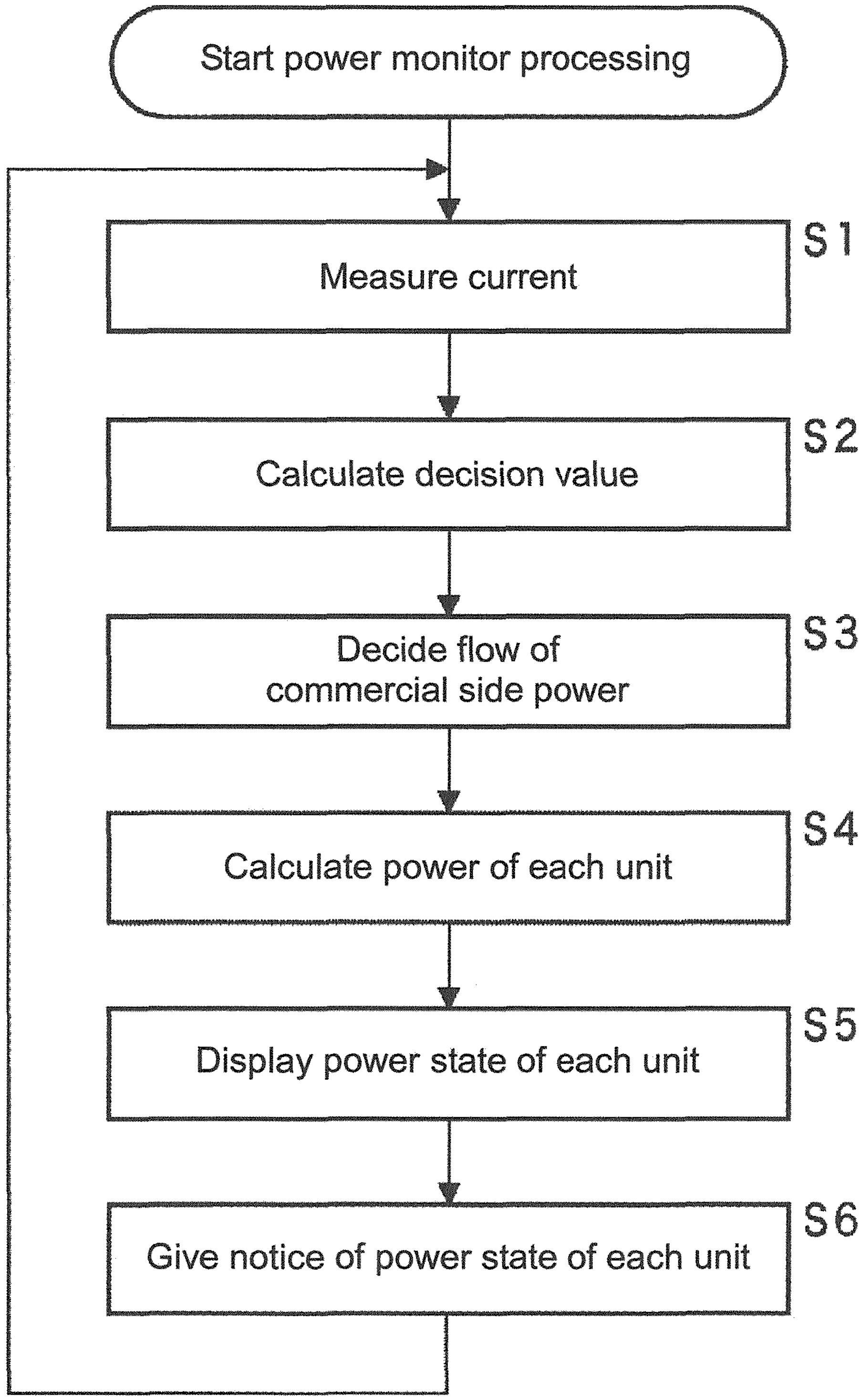
Start power monitor processing
S1
Measure current
S2
Calculate decision value
S3
Decide flow of commercial side power
S4
Calculate power of each unit
S5
Display power state of each unit
S6
Give notice of power state of each unit

FIG. 4

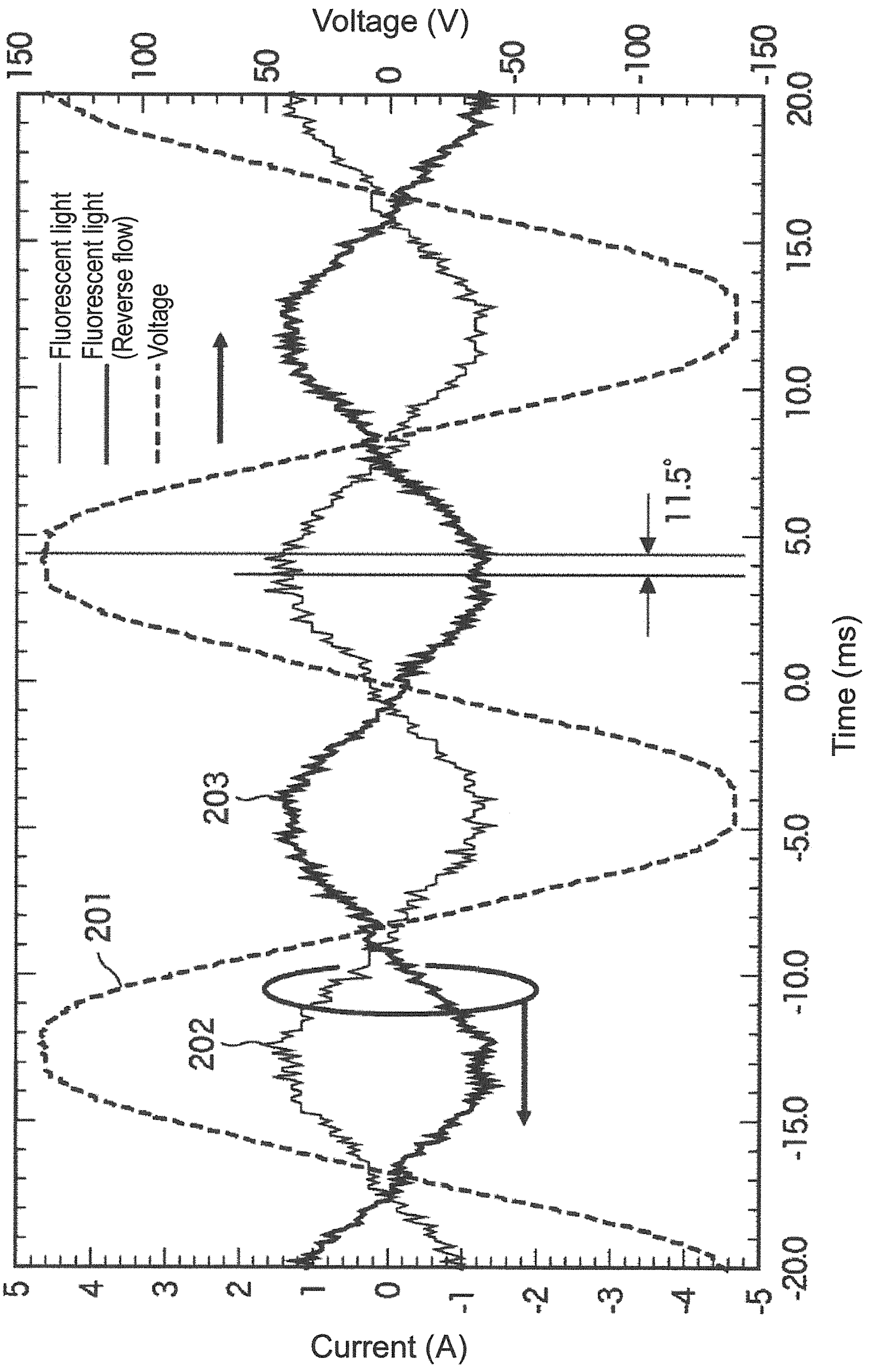
Voltage (V)
150
100
50
0
-50
-100
-150
Current (A)
5
4
3
2
1
0
-1
-2
-3
-4
-5
Time (ms)
-20.0
-15.0
-10.0
-5.0
0.0
5.0
10.0
15.0
20.0
Fluorescent light
Fluorescent light (Reverse flow)
Voltage
11.5°
201
202
203

FIG. 5

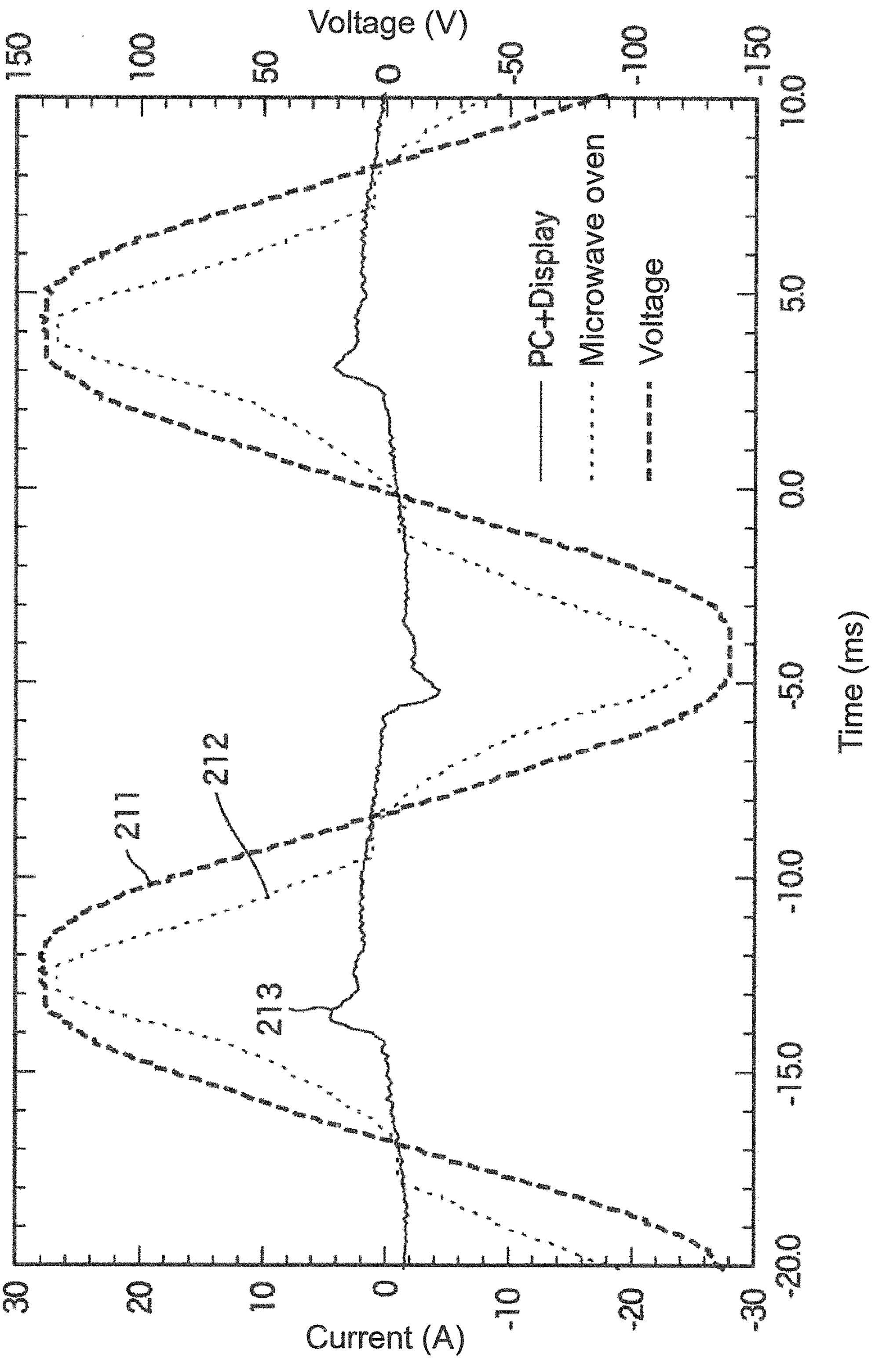
Voltage (V)
150
100
50
0
-50
-100
-150
30
20
10
0
-10
-20
-30
Current (A)
-20.0
-15.0
-10.0
-5.0
0.0
5.0
10.0
Time (ms)
PC+Display
Microwave oven
Voltage
211
212
213

FIG. 6

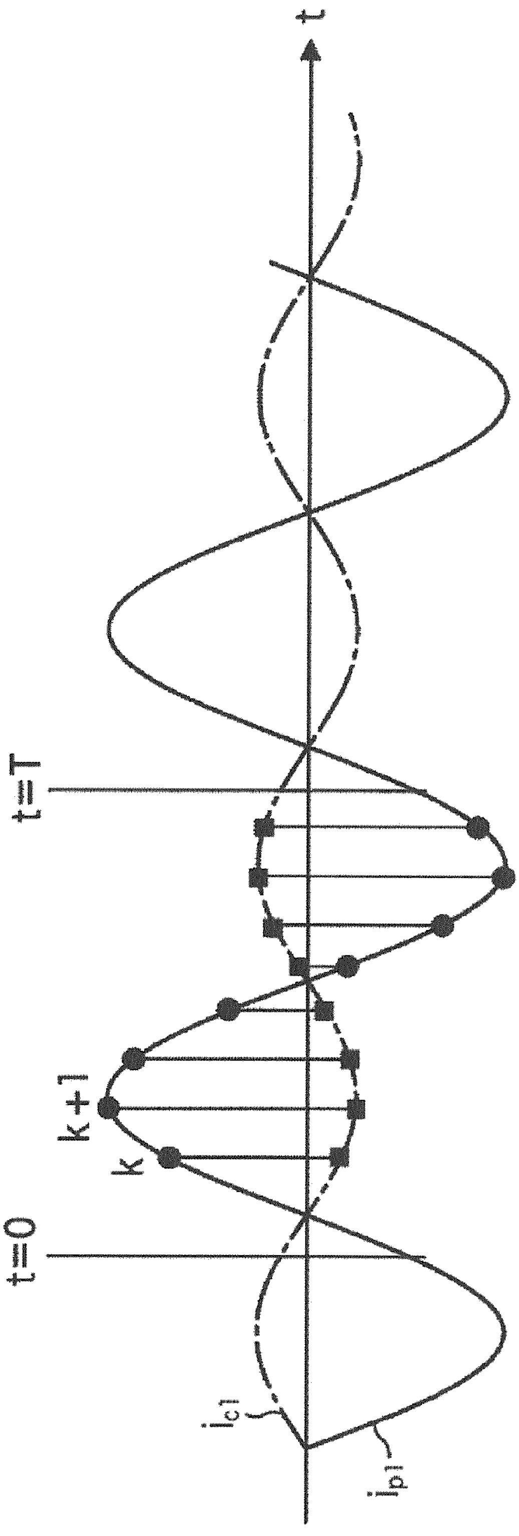

FIG. 7

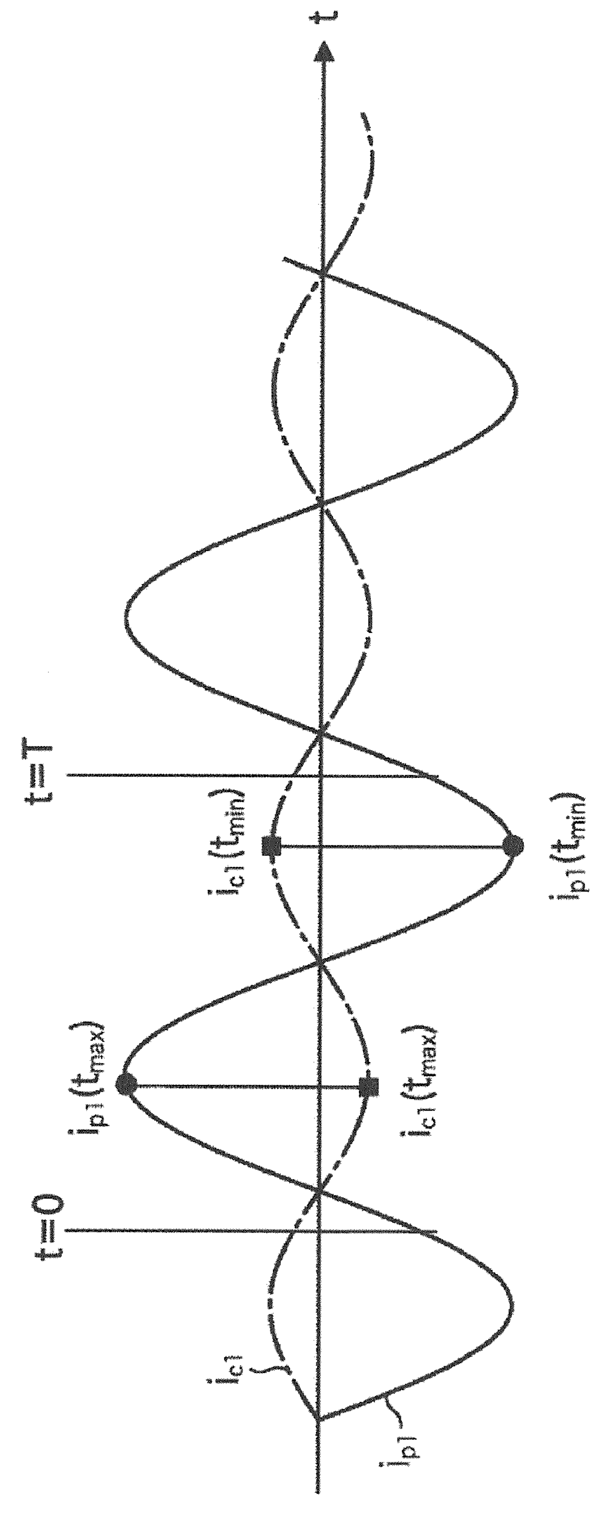

FIG. 8

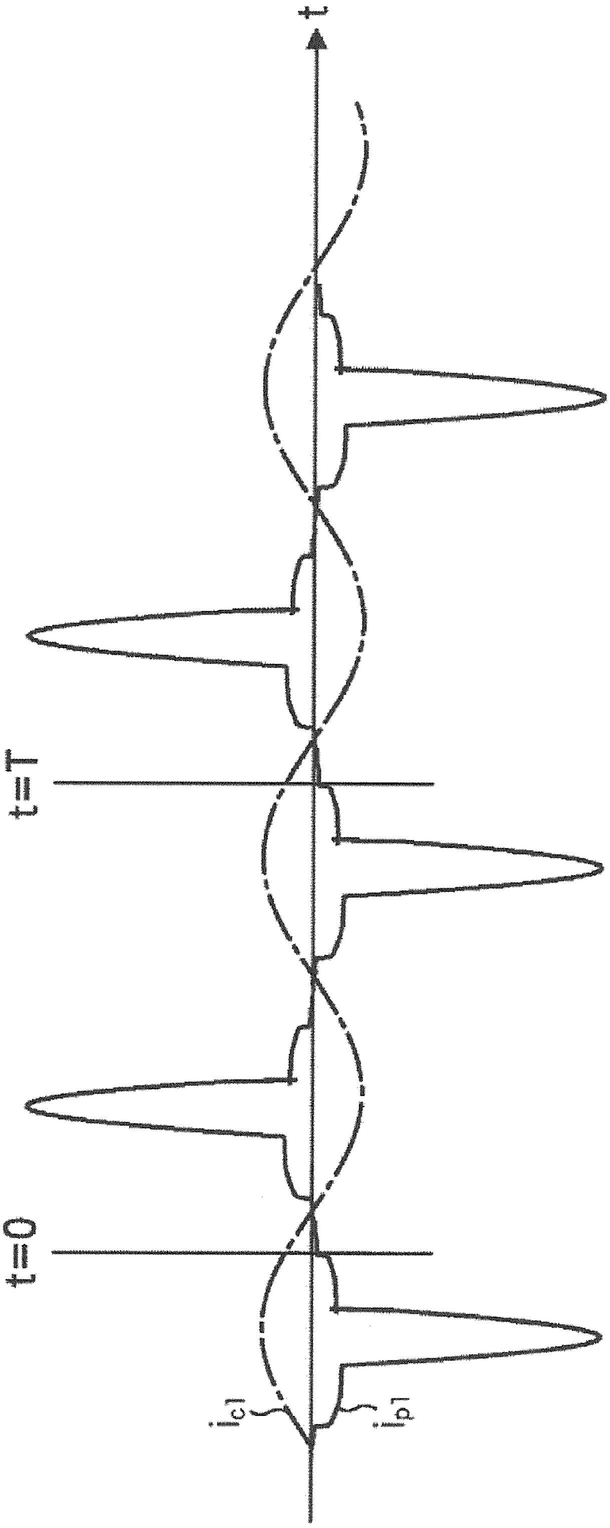

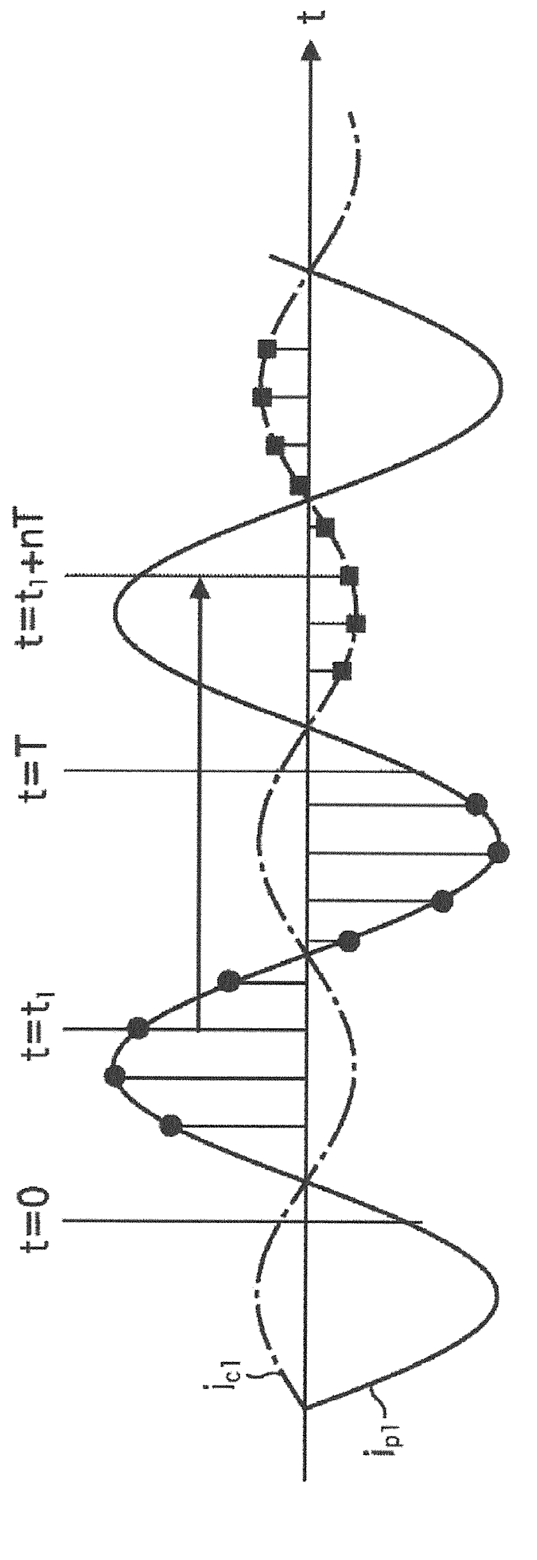


FIG. 9

FIG. 10

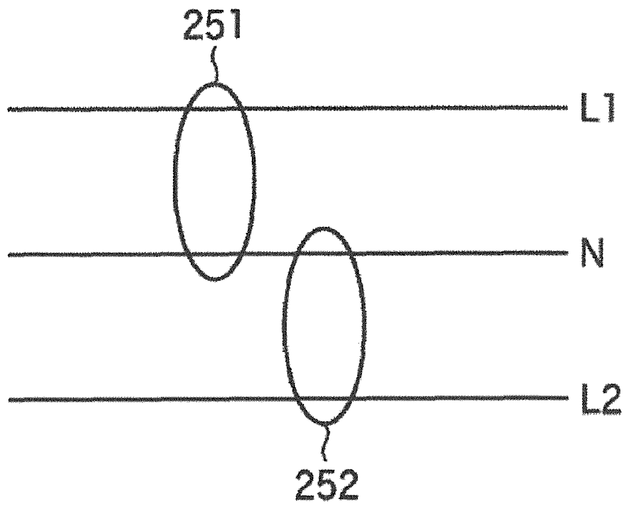


FIG. 11

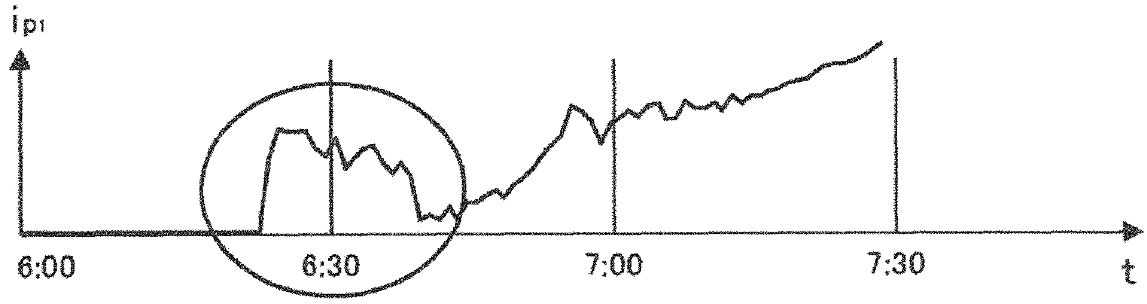


FIG. 12

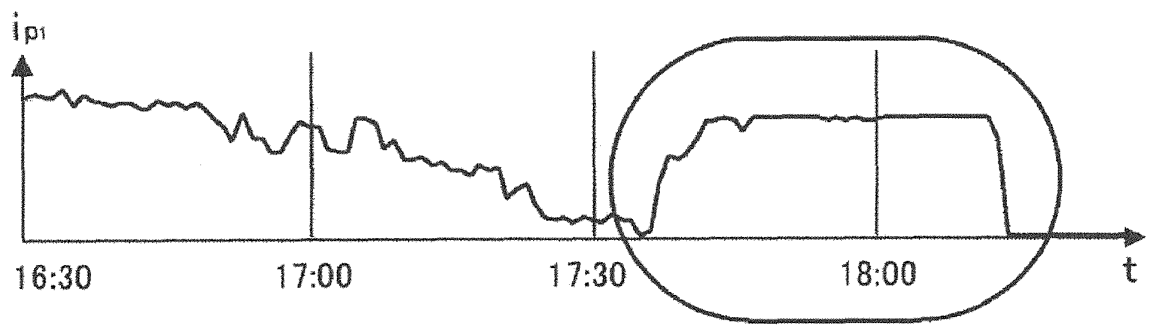

FIG. 13

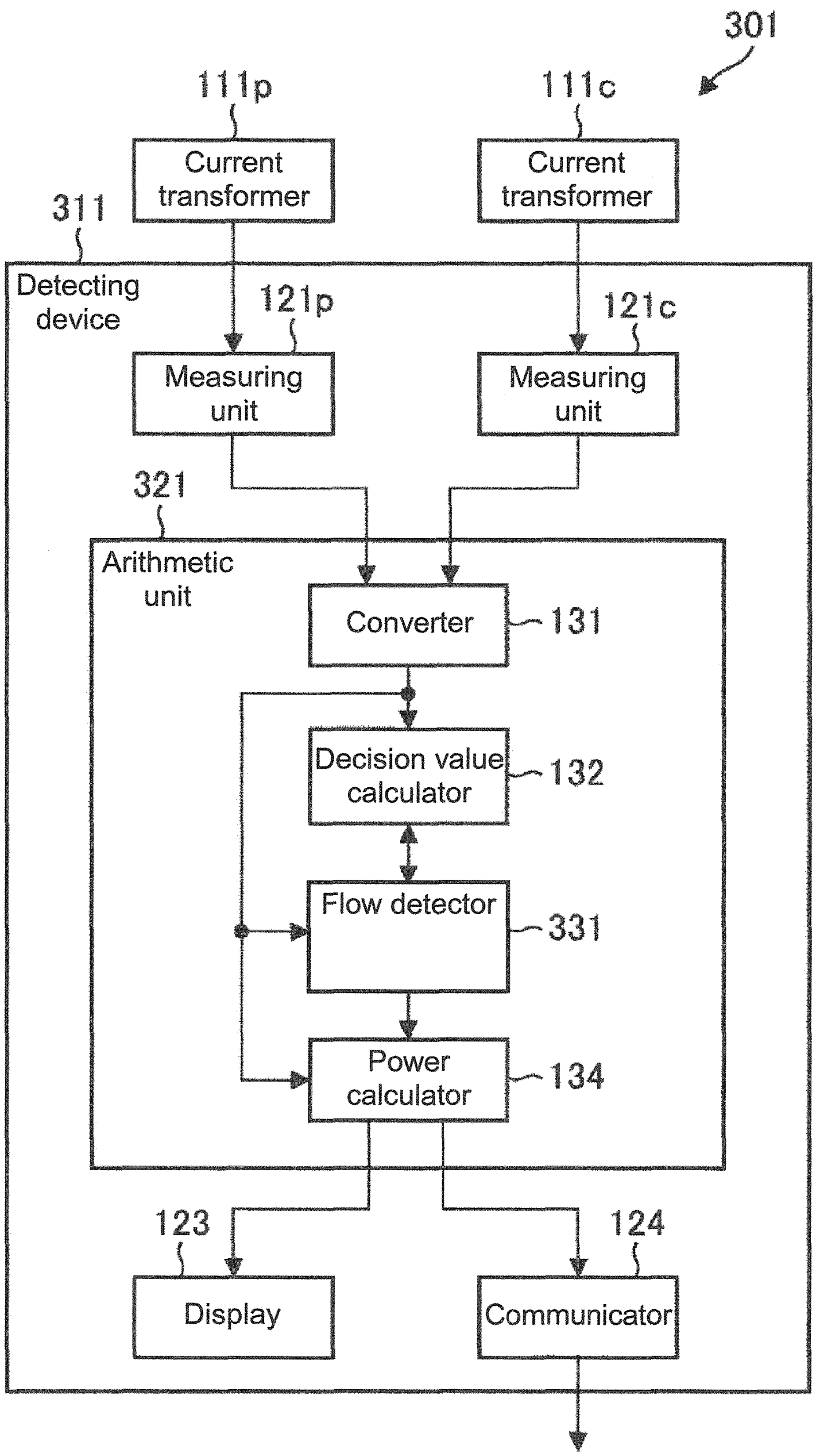
301
111p
111c
Current transformer
Current transformer
311
Detecting device
121p
121c
Measuring unit
Measuring unit
321
Arithmetic unit
Converter
131
Decision value calculator
132
Flow detector
331
Power calculator
134
123
124
Display
Communicator

FIG. 14

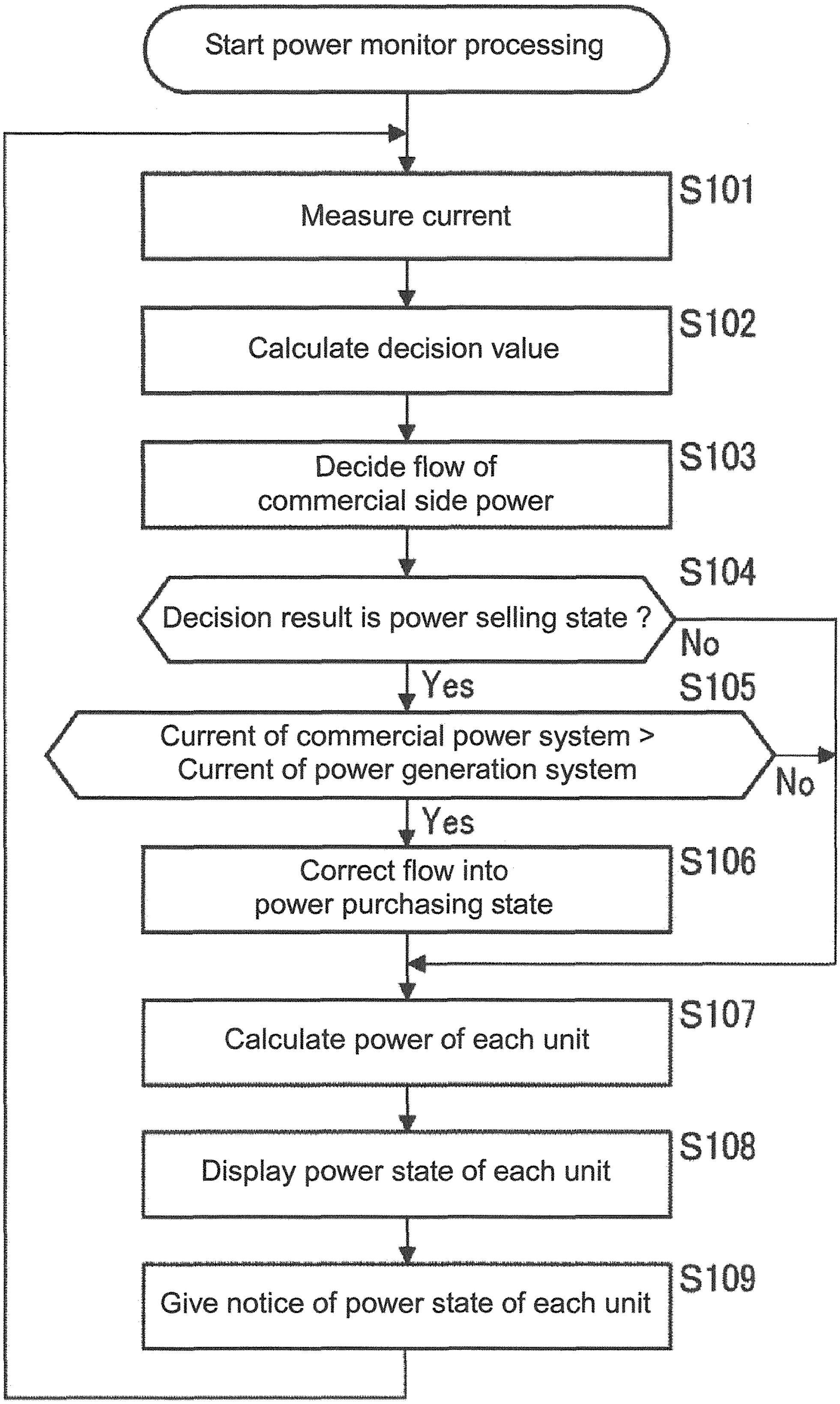
Start power monitor processing
S101
Measure current
S102
Calculate decision value
S103
Decide flow of commercial side power
S104
Decision result is power selling state ?
No
Yes
S105
Current of commercial power system > Current of power generation system
No
Yes
S106
Correct flow into power purchasing state
S107
Calculate power of each unit
S108
Display power state of each unit
S109
Give notice of power state of each unit

FIG. 15

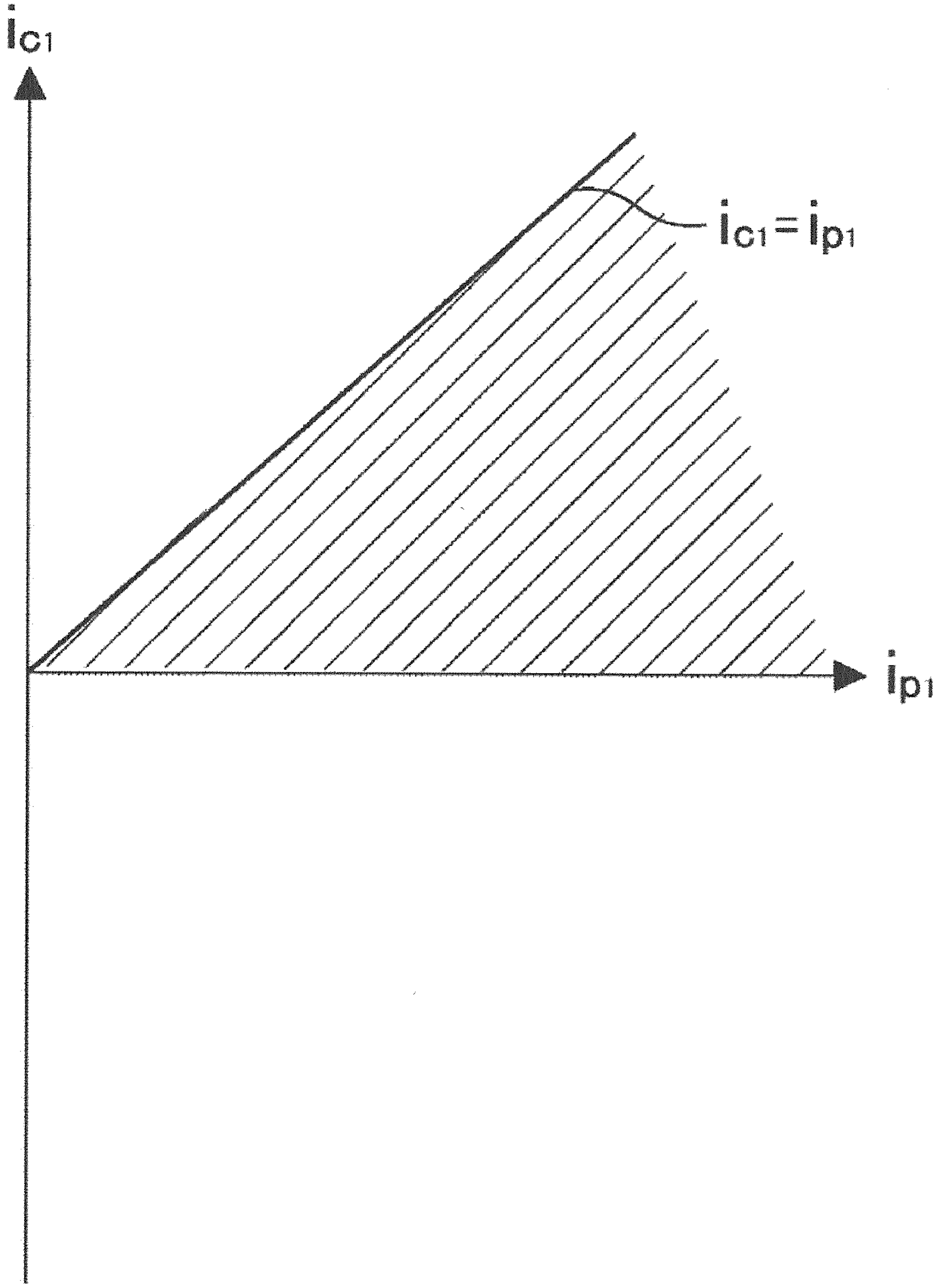

FIG. 16

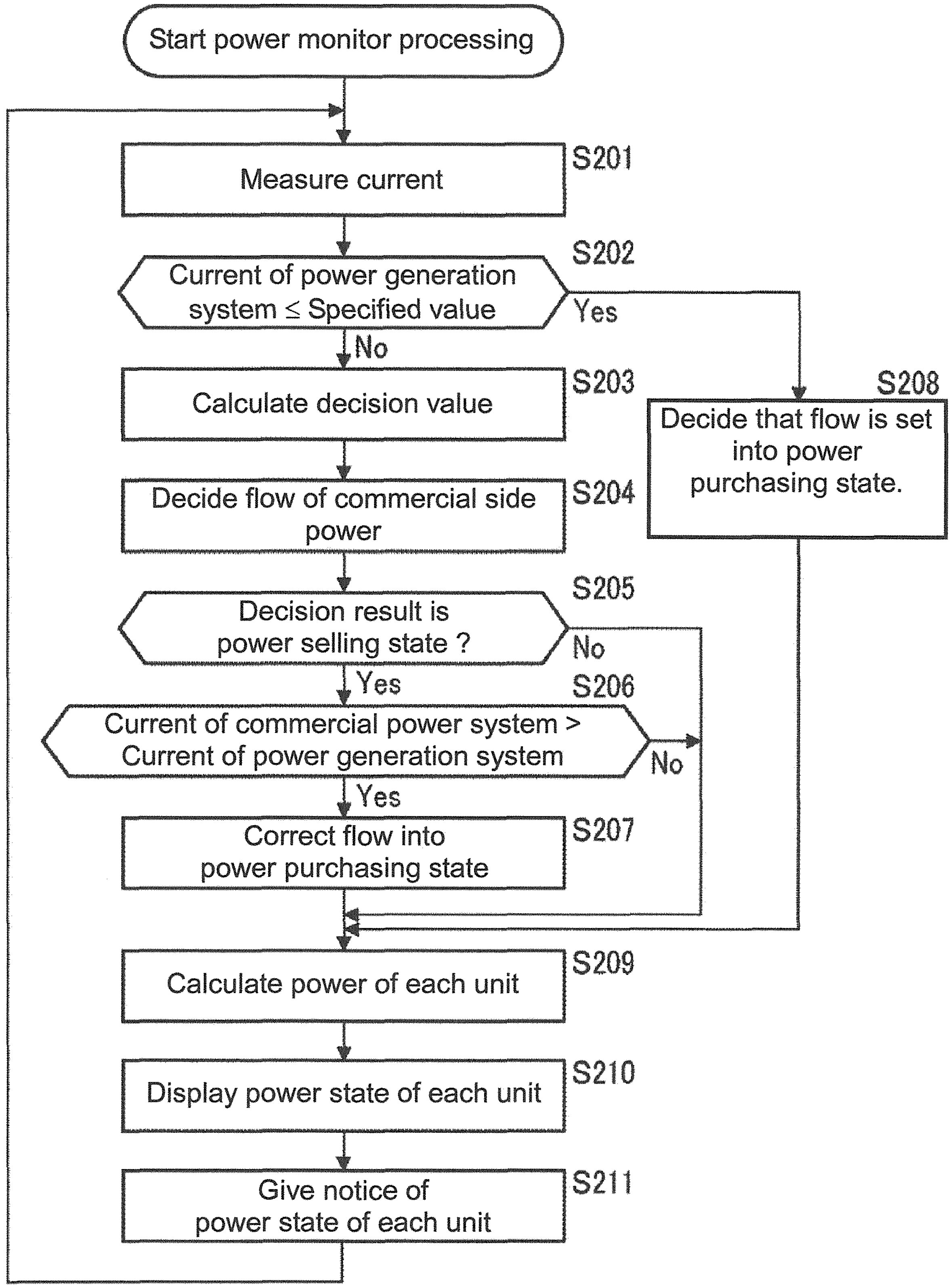
Start power monitor processing
Measure current
S201
Current of power generation system ≤ Specified value
S202
Yes
No
Calculate decision value
S203
Decide flow of commercial side power
S204
Decision result is power selling state ?
S205
No
Yes
Current of commercial power system > Current of power generation system
S206
No
Yes
Correct flow into power purchasing state
S207
Decide that flow is set into power purchasing state.
S208
Calculate power of each unit
S209
Display power state of each unit
S210
Give notice of power state of each unit
S211

FIG. 17

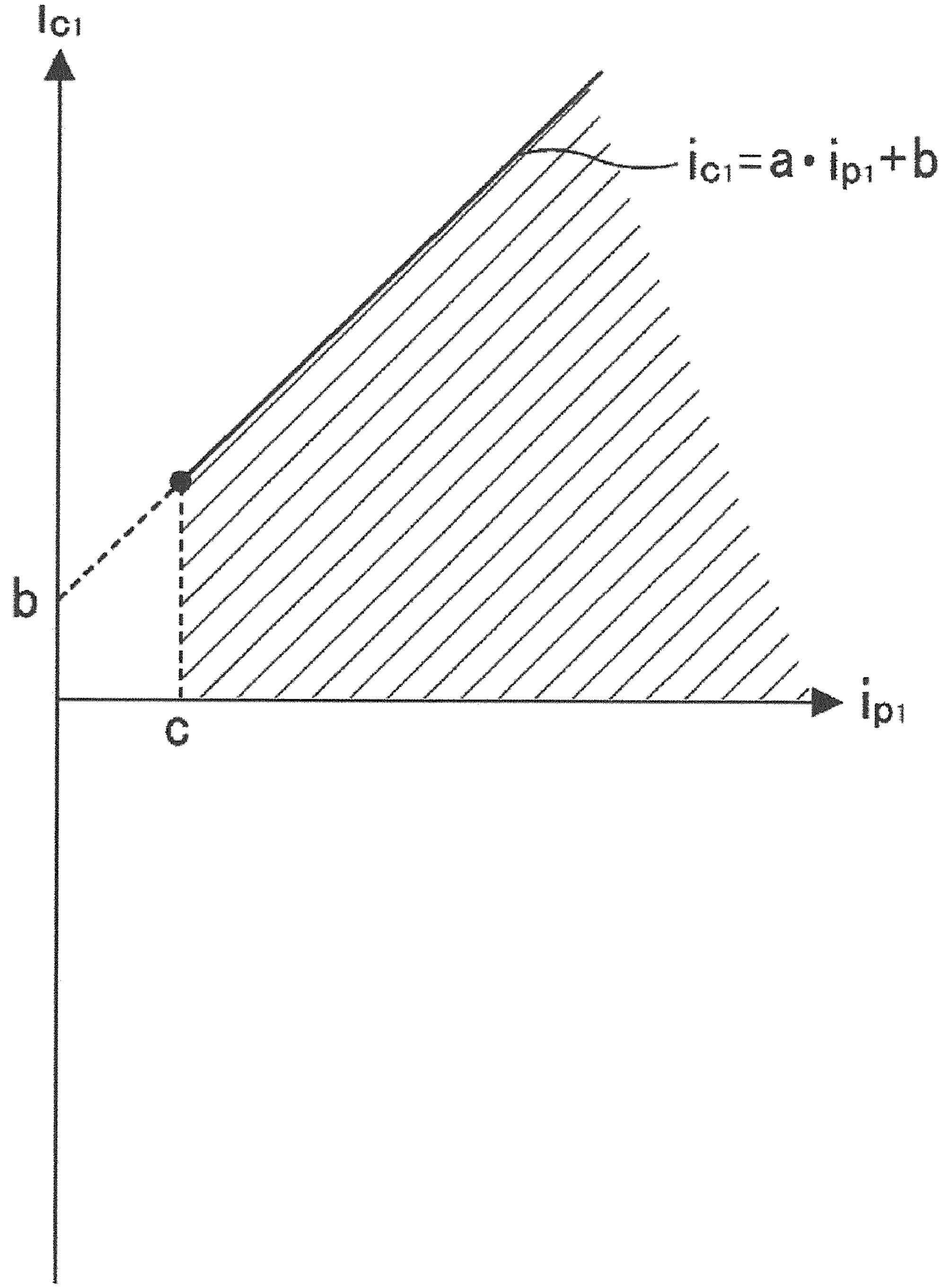

FIG. 18

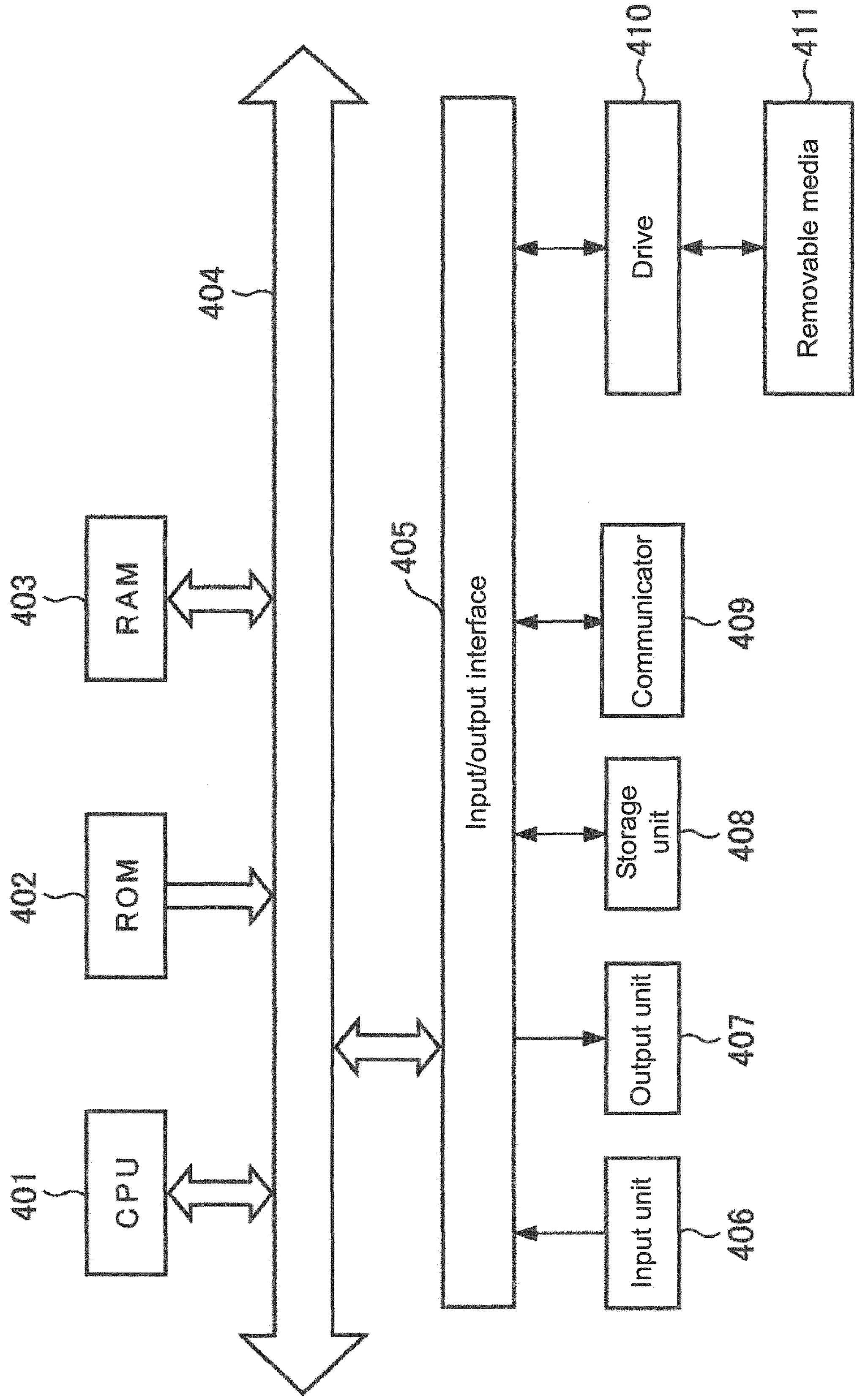
401
CPU
402
ROM
403
RAM
404
405
Input/output interface
406
Input unit
407
Output unit
408
Storage unit
409
Communicator
410
Drive
411
Removable media

## INTERNATIONAL SEARCH REPORT

International application No. PCT/JP2011/078444

A. CLASSIFICATION OF SUBJECT MATTER
*G01R22/00*(2006.01)i, *H02J3/38*(2006.01)i

According to International Patent Classification (IPC) or to both national classification and IPC

B. FIELDS SEARCHED

Minimum documentation searched (classification system followed by classification symbols)
G01R22/00, H02J3/38

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2010-141959 A (Toshiba Toko Meter Systems Co., Ltd.), 24 June 2010 (24.06.2010), paragraphs [0002] to [0004]; fig. 2 (Family: none) | 1-13 |
| A | JP 2010-107273 A (Kyocera Corp.), 13 May 2010 (13.05.2010), paragraphs [0017] to [0021]; fig. 1 (Family: none) | 1-13 |
| A | JP 2004-12376 A (Mitsubishi Electric Corp.), 15 January 2004 (15.01.2004), paragraphs [0016] to [0024]; fig. 1 (Family: none) | 1-13 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>05 March, 2012 (05.03.12) | Date of mailing of the international search report<br>13 March, 2012 (13.03.12) |
| Name and mailing address of the ISA/<br>Japanese Patent Office<br>Facsimile No. | Authorized officer<br><br>Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004279321 A
- JP 2004297959 A
- JP 11225440 A